# EUROPEAN PATENT APPLICATION

(11) **EP 4 216 275 A1**
(43) Date of publication of application: **26.07.2023**
(21) Application number: 21868759.8
(22) Date of filing: 18.09.2021
(51) Int. Cl.: H01L 25/075, H01L 33/48, H01L 21/67

(54) **SUBSTRATE, AND LED LIGHT SOURCE ASSEMBLY AND MANUFACTURING METHOD THEREFOR**

(30) Priority: 21.09.2020 CN 202010995828; 28.09.2020 CN 202011041450; 28.09.2020 CN 202011040024; 28.09.2020 CN 202011040061; 28.09.2020 CN 202011040131; 28.09.2020 CN 202022176328 U; 05.02.2021 CN 202110158644; 05.02.2021 CN 202110158667; 05.02.2021 CN 202120342329 U; 29.03.2021 CN 202110337273; 30.04.2021 CN 202110486258; 18.06.2021 CN 202110677484
(71) Applicant: Shenzhen Jufei Optoelectronics Co., Ltd., Shenzhen, Guangdong 518111 (CN)
(72) Inventor: HU, Yongheng, Shenzhen, Guangdong 518111 (CN); LI, Mingquan, Shenzhen, Guangdong 518111 (CN); CHEN, Ruibing, Shenzhen, Guangdong 518111 (CN); CHEN, Yanming, Shenzhen, Guangdong 518111 (CN); WEN, Gang, Shenzhen, Guangdong 518111 (CN); XIANG, Wendou, Shenzhen, Guangdong 518111 (CN); XU, Wenqin, Shenzhen, Guangdong 518111 (CN); XIE, Meng, Shenzhen, Guangdong 518111 (CN); SUN, Pingru, Shenzhen, Guangdong 518111 (CN); LI, Yunhua, Shenzhen, Guangdong 518111 (CN); XING, Meizheng, Shenzhen, Guangdong 518111 (CN); GAO, Siqing, Shenzhen, Guangdong 518111 (CN); CAO, Jintao, Shenzhen, Guangdong 518111 (CN); LIANG, Haizhi, Shenzhen, Guangdong 518111 (CN); LIU, Lepeng, Shenzhen, Guangdong 518111 (CN)
(74) Representative: Viering, Jentschura & Partner mbB Patent- und Rechtsanwälte
(86) International application number: PCT/CN2021/119458
(87) International publication number: WO 2022/057937

(57) **Abstract**

The present application relates to a substrate (3), an LED light source assembly and manufacturing methods therefor. The substrate (3) includes a first substrate (1) and a second substrate (2) which are arranged in a stacked manner. Electrode soldering regions (13) on the front side of the first substrate (1) and corresponding first conductive regions (14) on the back side of the first substrate (1) are electrically connected; and second conductive regions (22) on the front side of the second substrate (2) and corresponding third conductive regions (23) on the back side of the second substrate (2) are electrically connected, where the corresponding first conductive regions (14) and the corresponding second conductive regions (22) are electrically connected.

## Description

### BACKGROUND

### Technical Field

The present application relates to the field of LEDs (Light Emitting Diodes), and in particular to a substrate, an LED light source assembly and manufacturing methods therefor.

### Related Art

Backlights of LED displays of electronic products such as mobile phones, notebook computers and tablet computers in the market are mainly stent-type LED light sources. The stent-type LED light source means that an LED chip is placed on a separately prepared LED stent, then an individual LED light bead is obtained through encapsulation, and then the LED light bead is arranged on a circuit board of a backlight panel. The LED stent is much larger than the LED chip in size, and the LED stent has bent legs. When the LED light bead is placed onto the circuit board, in order to prevent short circuit between the adjacent LED light beads caused by solder bridging, the distance between pads on the circuit board needs to be greater than 0.5mm. This causes a larger distance between centers of the LED light beads as well as a larger color mixing distance, leading to a larger bezel of the LED backlight module. This traditional encapsulation form has gradually failed to meet the needs of users for miniaturization, integration and high brightness of the LED light beads. In particular, as the electronic products such as mobile phones, notebook computers and tablet computers are increasingly pursuing narrow bezels and thinness, the LED light beads as backlights also need to be smaller and thinner. According to the structural design of the traditional stent-type backlight product, reducing the structure of the LED stent will reduce the size of the LED chip, thus reducing the brightness of the LED light bead. However, for a backlight product, the requirements for the brightness of the LED light beads are constantly increasing, and a product with reduced brightness is bound to be unacceptable to consumers. Moreover, due to the limitation of the encapsulation process, the smaller the size of the LED light bead, the higher the encapsulation difficulty, the lower the yield and the higher the cost.

Therefore, how to simplify the manufacturing process of the backlight, improve the color mixing effect and reduce the manufacturing cost on the basis of meeting the demands for brightness is a technical problem that needs to be solved urgently at present.

### SUMMARY

### Technical Problems

In view of the defects in the prior art, the present application provides a substrate, an LED light source assembly and manufacturing methods therefor, in order to solve the problems of high cost, difficulty in meeting demands, complex process for manufacturing backlights and poor color mixing effect when using the stent-type LED light beads in the related art.

### Technical Solutions

Provided is a substrate, used for manufacturing an LED light source assembly. The substrate includes a first substrate and a second substrate arranged in a stacked manner.

A front side of the first substrate is provided with a die bonding region and at least two electrode soldering regions located in the die bonding region and configured to be respectively connected to positive and negative electrodes of an LED chip. A back side of the first substrate is provided with at least two first conductive regions respectively corresponding to the electrode soldering regions. The substrate further includes first conductive members embedded in the first substrate and electrically connecting the electrode soldering regions to the corresponding first conductive regions.

A front side of the second substrate is provided with at least two second conductive regions respectively corresponding to the first conductive regions, and the first conductive regions and the corresponding second conductive regions are electrically connected. A back side of the second substrate is provided with at least two third conductive regions respectively corresponding to the second conductive regions. The substrate further includes second conductive members embedded in the second substrate and electrically connecting the second conductive regions to the corresponding third conductive regions.

Based on the same inventive concept, the present application further provides a manufacturing method for the substrate described above, including:
forming at least two electrode soldering regions and at least two corresponding first conductive regions respectively on a front side and a back side of a first substrate through a gold plating process, and forming at least two corresponding second conductive regions and at least two corresponding third conductive regions respectively on a front side and a back side of a second substrate through a gold plating process; providing first through holes communicating the electrode soldering regions with the corresponding first conductive regions and second through holes communicating the second conductive regions with the corresponding third conductive regions respectively in the first substrate and the second substrate, and forming first conductive members and second conductive members respectively in the first through holes and the second through holes; and
aligning and bonding the back side of the first substrate to the front side of the second substrate, and electrically connecting first conductive regions to the corresponding second conductive regions.

Based on the same inventive concept, the present application further provides an LED light source assembly, including the substrate described above and further including an LED chip arranged in the die bonding region. Positive and negative electrodes of the LED chip are respectively electrically connected to the corresponding electrode soldering regions in the die bonding region.

Based on the same inventive concept, the present application further provides a manufacturing method for the LED light source assembly, including:
manufacturing a substrate by the manufacturing method for the substrate described above;
transferring an LED chip into a die bonding region on the substrate; and
electrically connecting the LED chip in the die bonding region to the corresponding electrode soldering regions.

### Beneficial Effects

The present application provides the substrate, the LED light source assembly and the manufacturings method therefor. The substrate includes the first substrate and the second substrate sequentially arranged from top to bottom. The front side of the first substrate is provided with the die bonding region and the at least two electrode soldering regions located in the die bonding region and used for connection respectively to the positive and negative electrodes of the LED chip, and the back side is provided with the at least two first conductive regions respectively corresponding to the electrode soldering regions. The substrate further includes the first conductive members embedded in the first substrate and electrically connecting the electrode soldering regions to the corresponding first conductive regions. The front side of the second substrate is provided with the at least two second conductive regions respectively corresponding to the first conductive regions, and the first conductive regions and the corresponding second conductive regions are electrically connected. The back side of the second substrate is provided with the at least two third conductive regions respectively corresponding to the second conductive regions. The substrate further includes the second conductive members embedded in the second substrate and electrically connecting the second conductive regions to the corresponding third conductive regions. The electrode soldering regions, the first conductive regions, the second conductive regions and the third conductive regions can be formed by the gold plating process, so the substrate has the advantages of simple manufacturing process, high manufacturing efficiency and low cost.

When the substrate provided in the present application is used for manufacturing the LED light source assembly, the LED chip can be directly arranged in the corresponding die bonding region on the substrate and respectively connected to the corresponding electrode soldering regions, which can simplify the process, improve the efficiency and yield and reduce the cost. Since the LED stents can be removed, compared with the existing single stent-type LED light beads, in a case that the same area is occupied on the circuit board, the LED chip with higher brightness and larger size can be arranged. In the case of the same area, when the LED chips with the same size as the stent-type LED light beads are arranged, more LED chips can be arranged, which can improve the overall brightness.

In addition, due to the removal of the LED stents, on the premise of no short circuit caused by solder bridging, the spacing between the adjacent LED chips can be set smaller than that of the stent-type LED light beads. The gap between the adjacent LED chips can be set to less than 0.3 mm, and the color mixing distance can be reduced, so the color mixing efficiency can be improved. When the manufactured LED light source assembly is a display panel assembly, the width of the bezel of the LED-backlight display can be further reduced, thereby improving the display effect.

Moreover, when the substrate provided in the present application is used for manufacturing the LED light source assembly, the LED chip is directly transferred into the die bonding region on the substrate, and the LED chip in the die bonding region is electrically connected to the corresponding electrode soldering regions. Therefore, the manufacturing method has the advantages of simple process and high yield, and can further reduce the cost.

### BRIEF DESCRIPTION OF THE DRAWINGS

FIG. 1 is a three-dimensional schematic view I of a substrate according to Embodiment I of the present application;
FIG. 2 is a three-dimensional schematic view II of the substrate according to Embodiment I of the present application;
FIG. 3 is a cutaway view of the substrate in FIG. 1 taken along line A-A;
FIG. 4 is a schematic structural view of first through holes in a first substrate according to Embodiment I of the present application;
FIG. 5 is a schematic structural view of first conductive members formed in the first substrate according to Embodiment I of the present application;
FIG. 6 is a schematic structural view of the first substrate in FIG. 3;
FIG. 7 is a schematic structural view of second through holes in a second substrate according to Embodiment I of the present application;
FIG. 8 is a schematic structural view of second conductive members formed in the second substrate according to Embodiment I of the present application;
FIG. 9 is a schematic structural view of third conductive regions formed on a back side of the second substrate according to Embodiment I of the present application;
FIG. 10 is a schematic structural view of a bonding layer formed on a front side of the second substrate according to Embodiment I of the present application;
FIG. 11 is a cutaway view of the second substrate in FIG. 8 taken along line B-B;
FIG. 12 is a schematic view I of a first conductive region and a second conductive region arranged in a non-overlapping manner according to Embodiment II of the present application;
FIG. 13 is a schematic view II of a first conductive region and a second conductive region arranged in a non-overlapping manner according to Embodiment II of the present application;
FIG. 14 is a cutaway view of G1 in FIG. 1;
FIG. 15 is a schematic exploded view of a substrate according to Embodiment II of the present application;
FIG. 16 is a schematic view showing coincident centers according to Embodiment II of the present application;
FIG. 17 is a schematic view showing non-coincident centers according to Embodiment II of the present application;
FIG. 18 is a schematic structural view showing a square formed by connecting lines formed by sequentially connecting first locating structures according to Embodiment II of the present application;
FIG. 19 is a schematic structural view showing a capsule including a first encapsulating adhesive layer according to Embodiment IV of the present application;
FIG. 20 is a schematic structural view showing the capsule including an encapsulating adhesive unit and a first reflective adhesive layer according to Embodiment IV of the present application;
FIG. 21 is a cutaway view of an LED light source assembly corresponding to a single die bonding region according to Embodiment IV of the present application;
FIG. 22 is a three-dimensional view of the LED light source assembly corresponding to the single die bonding region according to Embodiment IV of the present application;
FIG. 23 is a top view of the capsule including lens caps and a second reflective adhesive layer according to Embodiment IV of the present application;
FIG. 24 is a sectional view I of the capsule including the lens caps and the second reflective adhesive layer according to Embodiment IV of the present application;
FIG. 25 is a sectional view II of the capsule including the lens caps and the second reflective adhesive layer according to Embodiment IV of the present application;
FIG. 26 is a sectional view III of the capsule including the lens caps and the second reflective adhesive layer according to Embodiment IV of the present application;
FIG. 27 is a sectional view I of the capsule including a third reflective layer, a diffusion layer and a fourth reflective layer according to Embodiment IV of the present application;
FIG. 28 is a sectional view II of the capsule including the third reflective layer, the diffusion layer and the fourth reflective layer according to Embodiment IV of the present application;
FIG. 29 is a sectional view III of the capsule including the third reflective layer, the diffusion layer and the fourth reflective layer according to Embodiment IV of the present application;
FIG. 30 is a sectional view I of the capsule including a light shielding layer according to Embodiment IV of the present application;
FIG. 31 is a sectional view II of the capsule including the light shielding layer according to Embodiment IV of the present application;
FIG. 32 is a sectional view III of the capsule including the light shielding layer according to Embodiment IV of the present application;
FIG. 33 is a sectional view IV of the capsule including the light shielding layer according to Embodiment IV of the present application;
FIG. 34 is a sectional view V of the capsule including the light shielding layer according to Embodiment IV of the present application;
FIG. 35 is a sectional view VI of the capsule including the light shielding layer according to Embodiment IV of the present application;
FIG. 36 is a sectional view of an LED light source assembly including a light guide plate according to Embodiment V of the present application;
FIG. 37 is a schematic structural view of a light emitting unit in FIG. 36;
FIG. 38 is a schematic view I showing a shape of an accommodating groove in the light guide plate according to Embodiment V of the present application;
FIG. 39 is a schematic view II showing a shape of the accommodating groove in the light guide plate according to Embodiment V of the present application;
FIG. 40 is a schematic view III showing a shape of the accommodating groove in the light guide plate according to Embodiment V of the present application;
FIG. 41 is a schematic view of a diffusion portion on the light guide plate according to Embodiment V of the present application;
FIG. 42 is a schematic view I of a chip package structure according to Embodiment VI of the present application;
FIG. 43 is a schematic view II of the chip package structure according to Embodiment VI of the present application;
FIG. 44 is a schematic view III of the chip package structure according to Embodiment VI of the present application;
FIG. 45 is a schematic view IV of the chip package structure according to Embodiment VI of the present application;
FIG. 46 is a schematic view V of the chip package structure according to Embodiment VI of the present application;
FIG. 47 is a schematic view showing alignment of the chip package structure with a substrate according to Embodiment VI of the present application;
FIG. 48 is a schematic view showing the substrate provided with a solder according to Embodiment VI of the present application;
FIG. 49 is a schematic view of applying pressure to a carrier tape body according to Embodiment VI of the present application;
FIG. 50 is a schematic view of applying the pressure to the carrier tape body through a push rod according to Embodiment VI of the present application;
FIG. 51 is a schematic view I of the carrier tape body recovering from deformation according to Embodiment VI of the present application;
FIG. 52 is a schematic view of applying the pressure to the carrier tape body through the push rod with a push rod head according to Embodiment VI of the present application;
FIG. 53 is a schematic view II of the carrier tape body recovering from deformation according to Embodiment VI of the present application;
FIG. 54 is a schematic view of a first mask according to Embodiment VI of the present application;
FIG. 55 is a schematic view of a second mask according to Embodiment VI of the present application;
FIG. 56 is a schematic view showing a magnetron sputtering process according to Embodiment VI of the present application; and
FIG. 57 is a schematic structural view of a display panel according to Embodiment VI of the present application.

### DETAILED DESCRIPTION

In order to facilitate the understanding of the present application, the present application will be described more comprehensively with reference to the relevant accompanying drawings. Preferred implementations of the present application are shown in the accompanying drawings. However, the present application can be implemented in many different forms and is not limited to the implementations described herein. Rather, these implementations are provided to make the disclosure of the present application understood more thoroughly and comprehensively.

Unless otherwise defined, all technical and scientific terms used herein have the same meaning as commonly understood by those skilled in the art of the present application. The terms used in the specification of the present application are only for the purpose of describing specific implementations and are not intended to limit the present application.

### Embodiment I:

This embodiment provides a substrate used for manufacturing an LED light source assembly, which has the advantages of simple structure, low cost, high yield and simple and reliable soldering process. The LED light source assembly manufactured by using the substrate may be a complete-board LED light source including a plurality of LED chips. This complete-board LED light source can be called a display panel when applied to the field of displays. The complete-board LED light source assembly can also be cut to obtain individual LED light sources. The number of the LED chips included in the individual LED light sources obtained by cutting may be one, or two or more. When the number is two or more, the brightness of the LED light bead can be multiplied, which can better meet the demands for brightness in application scenarios in the field of backlights or illumination. Of course, the size of the substrate can also be directly set to the size corresponding to manufacturing the individual LED light source, so that cutting is not needed. For the convenience of understanding, this embodiment will illustrate the structure of the substrate below.

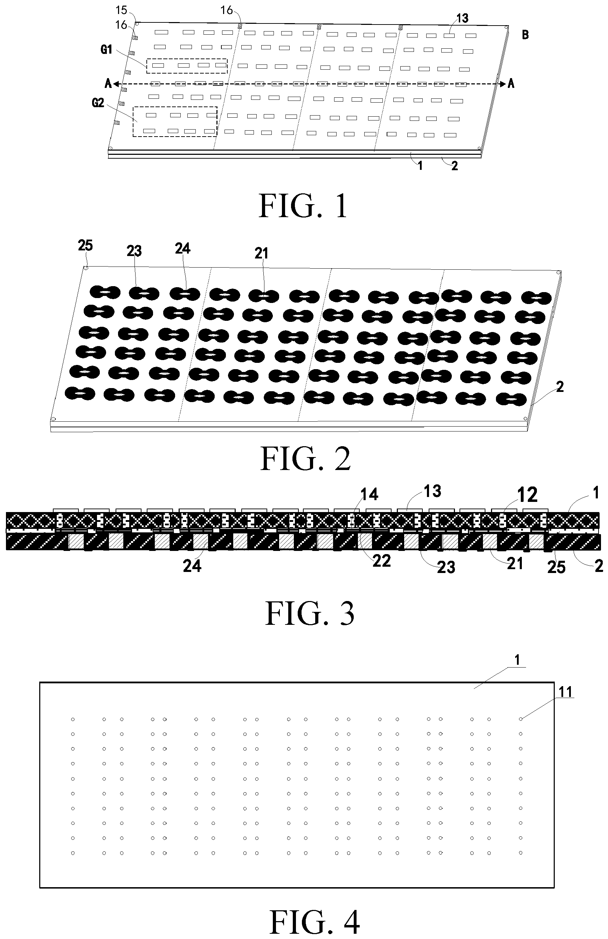

Referring to FIG. 1 to FIG. 3, the substrate in this embodiment includes a first substrate 1 and a second substrate 2 sequentially arranged in a stacked manner from top to bottom.

A material of the first substrate 1 may be, but not limited to, an insulating material. The first substrate 1 may be a rigid substrate, for example, but not limited to, a phenolic paper laminate, an epoxy paper laminate, a polyester glass felt laminate, an epoxy glass cloth laminate or a BT resin plate. The first substrate 1 in this embodiment may also be a flexible substrate, for example, but not limited to, a polyester film, a polyimide film or a fluorinated ethylene propylene film.

A front side of the first substrate 1 is provided with a die bonding region. The die bonding region may also be a light emitting region, which is configured to carry LED chips, and of course may also be configured to carry other chips, such as driver chips, capacitor chips, resistor chips, diodes, transistors and the like. At least two electrode soldering regions 13 configured to respectively connect positive and negative electrodes of an LED chip are arranged in the die bonding region. A back side of the first substrate 1 is provided with at least two first conductive regions 14 respectively corresponding to the electrode soldering regions 13. The substrate further includes first conductive members 12 embedded in the first substrate 1 and electrically connecting the electrode soldering regions 13 to the corresponding first conductive regions 14. The LED chips in this embodiment may be, but not limited to, normal LED chips, flip LED chips or vertical LED chips. In terms of size, the LED chips in this embodiment may be, but not limited to, micro-LED chips, mini-LED chips, normalsize chips or large-size LED chips.

It should be understood that in this embodiment, the number of the die bonding regions formed on the first substrate 1 can be set flexibly, for example, 1 or a plurality of die bonding regions may be arranged. When a plurality of die bonding regions are arranged, the die bonding regions can be distributed on the first substrate 1 in an array, or in other manners according to application demands, which will not be described here. In this embodiment, the number of the LED chips arranged in each die bonding region may be set flexibly according to specific demands. For example, one, or two or more LED chips may be arranged in each of the die bonding regions, or one LED chip may be arranged in part of the die bonding regions and two or more LED chips may be arranged in the rest of the die bonding regions. The specific number can be set flexibly according to demands. In this embodiment, for the die bonding region in which a plurality of LED chips are arranged, the plurality of LED chips in the die bonding region may be independent of each other without electrical connection. Alternatively, at least a part of the LED chips in the die bonding region may be connected in series, in parallel, or in series and in parallel according to demands. The electrode soldering regions 13 of the die bonding region can be arranged flexibly according to the specific relationship between the LED chips.

For example, an example is shown by G1 in FIG. 1. In this application example, the die bonding region G1 includes 4 electrode soldering regions 13. Every pair of adjacent electrode soldering regions 13 are used for electrical connection respectively to two electrodes of one LED chip, so 2 LED chips can be arranged in the die bonding region G1. The 2 LED chips arranged may be independent of each other or connected in series. When the LED chips are connected in series, the two electrode soldering regions 13 in the middle of the die bonding region G1 may use one common first conductive region 14. The die bonding region in another application example is shown by G2 in FIG. 1. This die bonding region can carry twice the number of the LED chips the die bonding region shown by G1 can. Of course, the arrangement of the die bonding regions in this embodiment can be set flexibly according to demands. It should be understood that in the embodiment, a complete-board LED light source assembly can be manufactured in the form of the first substrate 1 shown in FIG. 1, or an individual-bar LED light source assembly can be obtained by cutting in units of rows or columns, or an individual LED light bead can be obtained by cutting in units of individual die bonding regions, which depends on the specific application demands. When the complete-board LED light source assembly or individual-bar LED light source assembly is used directly, the spacing between the adjacent LED chips can be much smaller than that between the adjacent stent-type LED light beads, so that more LED chips can be arranged in the same space, which can improve both the brightness and the color mixing effect.

A material of the second substrate 2 in this embodiment may also be, but not limited to, an insulating material. It should be understood that the second substrate 2 in this embodiment may also be a rigid substrate or a flexible substrate. It should be understood that in this embodiment, the material of the second substrate 2 may be the same as or different from that of the first substrate 1, and the first substrate and the second substrate may have the same thickness or different thicknesses according to demands.

A front side of the second substrate 2 is provided with at least two second conductive regions 22 respectively corresponding to the first conductive regions 14, and the first conductive regions 14 and the corresponding second conductive regions 22 are electrically connected. A back side of the second substrate 2 is provided with at least two third conductive regions 23 respectively corresponding to the second conductive regions 22. The substrate further includes second conductive members 24 embedded in the second substrate 2 and electrically connecting the second conductive regions 22 to the corresponding third conductive regions 23. In this way, the electrode soldering regions 13 on the first substrate 1 can be electrically connected to the corresponding third conductive regions 23 on the back side of the second substrate 2 sequentially through the first conductive regions 14 and the second conductive regions 22 corresponding thereto, and the third conductive regions 23 on the back side of the second substrate 2 can be used as pads for external electrical connection. Therefore, the substrate provided in this embodiment can replace the stents in the traditional stent-type LED light source. During the preparation of the LED light source assembly, the LED chips may be directly transferred into the corresponding die bonding region on the front side of the first substrate 1 and then soldered with the corresponding electrode soldering regions 13, which can simplify the process, improve the efficiency and the yield and reduce the cost. Compared with the existing single stent-type LED light bead, in a case that the same area is occupied on the circuit board, the LED chip with higher brightness and larger size can be arranged. In the case of the same area, when the LED chips with the same size as the stent-type LED light beads are arranged, more LED chips can be arranged, which can improve the overall brightness. In addition, due to the removal of the LED stents, on the premise of no short circuit caused by solder bridging, the spacing between the adjacent LED chips can be set smaller than that of the stent-type LED light beads. The gap between the adjacent LED chips can be set to less than 0.3 mm, and the color mixing distance can be reduced, so the color mixing efficiency can be improved. When the manufactured LED light source assembly is a display panel assembly, the width of the bezel of the LED-backlight display can be further reduced, thereby improving the display effect.

It should be understood that in this embodiment, the first conductive members 12 embedded in the first substrate 1 may be arranged flexibly. For example, in an example, referring to FIG. 4, the first substrate 1 is further formed with first through holes 11 communicating the electrode soldering regions 13 with the corresponding first conductive regions 14 on the front side and the back side of the first substrate 1, and first conductive members 12 formed in the first through holes 11 and electrically connecting the electrode soldering regions 13 with the first conductive regions 14. It should be understood that in this embodiment, a cross-sectional shapes of the first through holes 11 may be set flexibly, which may be, for example, regular shapes, i.e., the first through holes may be, for example, circular holes, rectangular orifices, rhombic holes, hexagonal holes, triangular holes, elliptical holes or the like. The first through holes may also be in non-regular shapes. The first through holes 11 may have the same shape or different shapes according to demands, or a part of the first through holes 11 have the same shape and the rest have different shapes. In this embodiment, the sizes of the first through holes 11 may be set flexibly according to demands. For example, the diameters of the first through holes 11 may be, but not limited to, 0.04 mm-0.25 mm. For example, the diameters of the first through holes may be 0.04 mm, 0.05 mm. 0.08 mm, 0.1 mm, 0.15 mm, 0.2 mm or 0.25 mm according to demands.

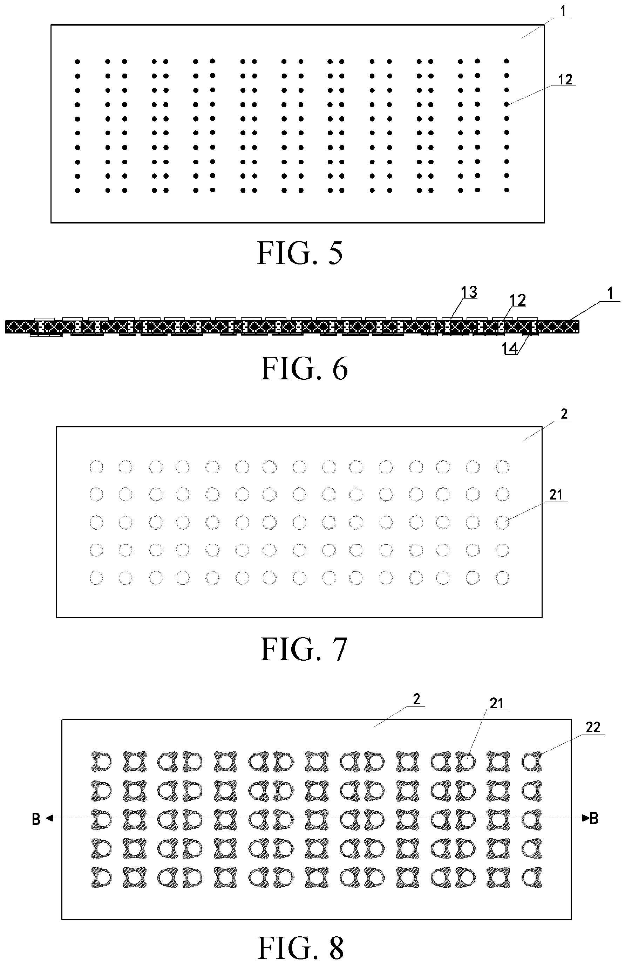

In an example of this embodiment, the first conductive members 12 formed in the first through holes 11 and electrically connecting the electrode soldering regions 13 to the first conductive regions 14 may be only conductive layers formed on side walls of the first through holes 11, and these conductive layers may completely or partially cover the side walls of the first through holes 11 and do not fully fill the first through holes 11. The conductive layers may be metal layers with good conductivity, which are called first metal conductive layers, and of course may be made of other materials, such as a conductive adhesive or the like. In another example of this embodiment, the first conductive members 12 formed in the first through holes 11 and electrically connecting the electrode soldering regions 13 to the first conductive regions 14 may also be conductive pillars fully filling the first through holes 11, for example, as shown in FIG. 5 and FIG. 6. It should be understood that the conductive pillars in this embodiment may be made of any material with good conductivity, for example, a conductive metal, a conductive adhesive or the like. The conductive metal may be at least one of, but not limited to, Au, Pt, Pd, Rh, Ni, W, Mo, Cr, Ti, Fe, Cu, Al, Ag, etc. When the conductive pillars are made of a metal material, the conductive pillars in this example are called metal conductive pillars.

As can be seen, according to the substrate provided in this embodiment, the first conductive members 12 can be previously embedded alone in the first substrate by a mature process, which achieves simple process, high manufacturing efficiency and yield and low cost. In addition, compared with the single-layer substrate with the same thickness, the height of the first conductive members 12 is only half of that of the single-layer substrate or even smaller, so the path for dissipating heat generated by the operation of the LED chips can be greatly shortened, thus obtaining better heat dissipation performance. In particular, when the first conductive members 12 are metal conductive pillars, the conductivity can be improved, and the heat dissipation effect and the luminous performance of the LED chips can be further improved.

In this embodiment, all the first through holes 11 may be provided with the first metal conductive layers or the metal conductive pillars, or a part of the first through holes 11 may be provided with the first metal conductive layers and the rest of the first through holes 11 are provided with the metal conductive pillars, which depends on the specific application demands.

In this embodiment, the second conductive members 24 embedded in the second substrate 2 may be arranged flexibly. For example, in an example shown in FIG. 3 and FIG. 7 to FIG. 11, the second substrate 2 is provided with second through holes 21 communicating the second conductive regions 22 with the corresponding third conductive regions 23. The second conductive members 24 are second metal conductive layers formed on side walls of the second through holes 21. It should be understood that in other examples of this embodiment, the second conductive members 24 may fully fill the second through holes 21. In this embodiment, cross-sectional shapes of the second through holes 21 may also be set flexibly, which may be, for example, regular shapes or non-regular shapes. The second through holes 21 may have the same shape or different shapes according to demands, or a part of the second through holes 21 have the same shape and the rest have different shapes. It should be understood that in this embodiment, the first through holes 11 and the second through holes 21 may have the same shape or different shapes. The first through holes 11 and the second through holes 21 may have the same size or different sizes according to demands. For example, in an application example, the diameters of the second through holes 21 may be, but not limited to, 0.2 mm-0.75 mm. For example, the diameters of the second through holes 21 may be 0.2 mm, 0.25 mm, 0.38 mm, 0.4 mm, 0.5 mm, 0.6 mm or 0.75 mm.

In an example of this embodiment, referring to FIG. 3 and FIG. 4, the first through holes 11 do not correspond to the second through holes 21 in position. That is, after the first substrate 1 and the second substrate 2 are aligned and stacked, the first through holes 11 and the second through holes 21 do not overlap, or only partially overlap. This staggered arrangement of the first through holes 11 and the second through holes 21 can improve the overall strength of the substrate formed after the first substrate 1 and the second substrate 2 are aligned and stacked. The first conductive members 12 in the first through holes 11 are electrically connected to the second conductive members 24 in the second through holes 21 through the first conductive regions 14 and the second conductive regions 22 corresponding thereto, and there is no need for electrical connection through hole-to-hole alignment, so that the alignment is simpler and more accurate and the formed substrate has better reliability. The third conductive regions 23 can be used as the pads for external soldering. A solder, such as a solder paste used during soldering, can retract into the second through holes 21, which thereby avoids a short circuit with the solder on the adjacent pads. This is conducive to the arrangement of small-size LED chips and small spacing, and helps to improve the color mixing effect.

In some examples of this embodiment, referring to FIG. 3, the substrate further includes a bonding layer 25 for aligning and bonding the first substrate 1 and the second substrate 2. After the first substrate 1 and second the second substrate 2 are bonded, the first conductive region 14 and the corresponding second conductive region 22 are electrically connected. The aligning and bonding of the first substrate 1 and the second substrate 2 through the bonding layer 25 is low in cost and simple in process, and the obtained substrate is reliable in structure. A material of the bonding layer 25 in this embodiment may be an insulating material, and of course, may also be a conductive material. In the case of the conductive material, it is necessary to prevent the bonding layer from causing a short circuit of other electrical connection regions (for example, between adjacent first conductive regions and between adjacent second conductive regions). Of course, it should be understood that in this embodiment, the fixing manner between the first substrate 1 and the second substrate 2 is not limited to bonding, and may also be various snap-fits or any other manners that can realize reliable fixation therebetween, which will not be described in detail.

In this embodiment, when the first substrate 1 and the second substrate 2 are aligned and bonded by the bonding layer 25, the substrate may further include at least one of a first bonding layer and a second bonding layer. The first bonding layer is arranged on the back side of the first substrate 1 and in a region other than the first conductive regions 14, and the second bonding layer is arranged on the front side of the second substrate 2 and in a region other than the second conductive regions 22. The first substrate 1 and the second substrate 2, when being arranged in the stacked manner, are bonded and fixed through at least one of the first bonding layer and the second bonding layer.

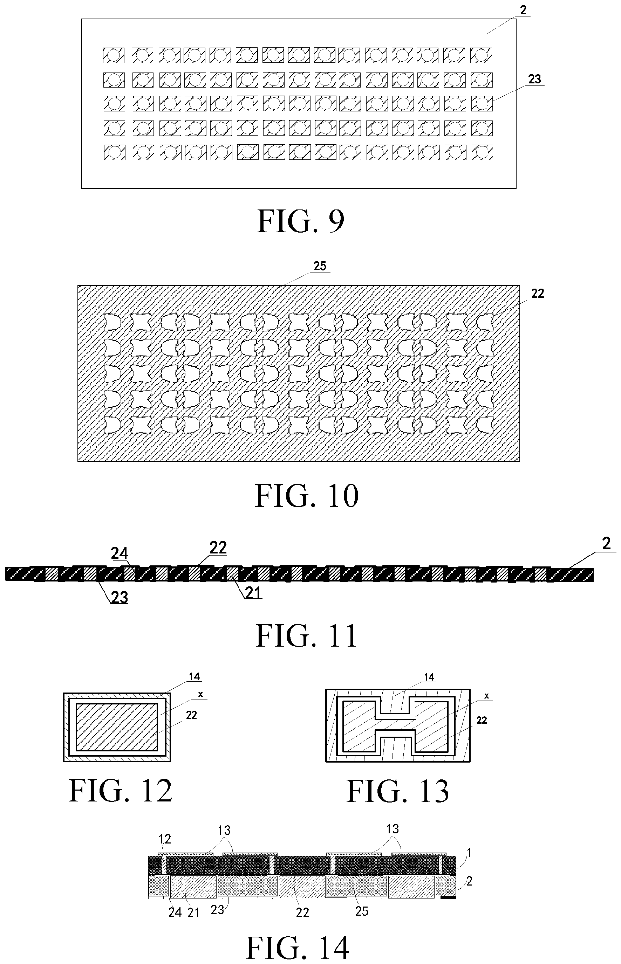

In this embodiment, referring to FIG. 10, an adhesive may be applied to the front side of the second substrate 2 in the region other than the second conductive regions 22 to form the bonding layer 25 (i.e., the second bonding layer). Of course, the adhesive may also be applied to the back side of the first substrate 1 in the region other than the first conductive regions 14 to form the bonding layer 25, or the adhesive may be applied to both the first substrate 1 and the second substrate 2 to form the bonding layer 25. Then, the aligning and bonding between the first substrate 1 and the second substrate 2 is completed.

In some examples of this embodiment, in order to further ensure the accurate alignment between the first substrate 1 and the second substrate 2, the first substrate 1 may be provided with at least three first alignment holes, and at least three of the first alignment holes are not on a same straight line. The second substrate 2 may be provided with at least three second alignment holes or at least three alignment protrusions corresponding to the first alignment holes. When the first substrate 1 and the second substrate 2 are arranged in the stacked manner, the alignment between the first substrate 1 and the second substrate 2 is realized through the alignment between the first alignment holes and the corresponding second alignment holes, or between the first alignment holes and the corresponding alignment protrusions. For example, referring to FIG. 1 and FIG. 2, the accurate alignment and connection can be realized through three first alignment holes 15 that are arranged on the first substrate 1 and connected to form a triangle, and second alignment holes 25 or protrusions arranged on the second substrate 2 in corresponding positions. Optionally, when the substrate needs to be diced, the substrate can be diced in units of rows, or columns, or one or multiple die bonding regions according to cutting marks 16 as shown in FIG. 1, to obtain a plurality of pieces of substrates.

It should be understood that in some examples of this embodiment, the first conductive regions 14 may be formed by ends of the first conductive members 12 in the first through holes 11 located on the back side of the first substrate 1. This equivalent substitution is also within the scope of protection of this embodiment.

In this embodiment, a pair of the first conductive region 14 and the corresponding second conductive region 22 on the first substrate 1 and the second substrate 2 may at least partially overlap or not overlap, for example:
In an example, in at least one pair of the first conductive region 14 and the corresponding second conductive region 22, after the first substrate and the second substrate are aligned and bonded, the first conductive region 14 is located directly above the second conductive region 22, and the first conductive region 14 and the second conductive region 22 at least partially overlap. In this implementation, "at least partially overlap" includes "the first conductive region 14 and the second conductive region 22 completely overlap," and "the first conductive region 14 and the second conductive region 22 overlap but not completely overlap."

In another example, in at least one pair of the first conductive region 14 and the corresponding second conductive region 22, after the first substrate and the second substrate are aligned and bonded, the first conductive region 14 and the second conductive region 22 do not overlap. For the convenience of understanding, the following description will take two examples in which the first conductive region 14 and the second conductive region 22 do not overlap.

Refer to FIG. 12 for an example. The second conductive region 22 is in the shape of a rectangle, and the first conductive region 14 is in the shape of a hollow rectangle. After the first substrate 1 and the second substrate 2 are aligned and bonded, the second conductive region 22 is located in a middle region of the first conductive region 14, and there is a gap x therebetween. Before the first substrate 1 and the second substrate 2 are aligned and bonded, the middle region of the first conductive region 14 of the first substrate may be filled with a conductive material to form reliable electrical connection.

Refer to FIG. 13 for another example. This example is different from FIG. 12 mainly in that the first conductive region 14 and the second conductive region 22 have different shapes. It should be understood that in FIG. 12 and FIG. 13, the first conductive region 14 may be in the shape of a rectangle, and the second conductive region 22 may be in the shape of a hollow rectangle, i.e., the first conductive region 14 may be located in the second conductive region 22. Compared with the overlapping arrangement, this non-overlapping arrangement can reduce the thickness of one coating, thereby reducing the overall thickness of the substrate and helping to realize small size.

In this embodiment, in order to improve the reliability of the electrical connection between the first conductive region 14 and the corresponding second conductive region 22 in pair, the substrate further includes a conductive adhesive layer filled between the first conductive region 14 and the second conductive region 22 to electrically connect the first conductive region 14 to the second conductive region 22. That is, the first conductive region 14 and the corresponding second conductive region 22 may be electrically connected through a flexible conductive layer. This can improve not only the reliability of the electrical connection between the first conductive region 14 and the corresponding second conductive region 22, but also the bonding tightness between the first substrate and the second substrate, thereby improving the air tightness of the prepared LED light source assembly and protecting the LED light source assembly.

It should be understood that in this embodiment, the shapes and thicknesses of the electrode soldering regions 13, the first conductive regions 14, the second conductive regions 22 and the third conductive regions 23 may be set flexibly according to demands. For example, in an example of this embodiment, the first conductive regions 14 and the second conductive regions 22 may have the same thickness or different thicknesses, and the same shape or different shapes. Accordingly, the shapes and thicknesses of the other electrodes may also be set flexibly.

Optionally, in this embodiment, in order to improve the soldering effect and performance between the electrode soldering regions 13 and the LED chips and/or improve the soldering performance and effect of between the third conductive regions 23 and external corresponding soldering regions, the electrode soldering regions 13 may include a copper coating formed on the first substrate 1, a nickel coating formed on the copper coating, and a gold coating formed on the nickel coating; and/or the third conductive regions 23 may include a copper coating formed on the second substrate 2, a nickel coating formed on the copper coating, and a gold coating formed on the nickel coating. Of course, at least one of the electrode soldering regions 13 and the third conductive regions 23 may be a single-layer film structure, which, in this case, may be made of, but not limited to, any one of the above-mentioned metal materials. It should be understood that in this embodiment, the structure and the material of the first conductive regions 14 and the second conductive regions 22 may be set in a similar manner.

In this embodiment, when at least one die bonding region on the first substrate 1 is configured to hold a plurality of LED chips, any of the following arrangements may be adopted to further simplify the circuit, reduce the cost and improve the manufacturing efficiency.

For example, when at least a part of the LED chips in the die bonding regions are connected in series, in parallel, or in series and in parallel according to demands, at least one of the electrode soldering regions 13 in the die bonding regions may be used as a common electrode for electrically connecting the electrodes of at least two LEDs.

Or, at least one of the first conductive regions 14 is used as a common electrode for electrically connecting the at least two corresponding electrode soldering regions 13 in the die bonding region. In this case, the electrode soldering regions 13 in the die bonding region may no longer be used as the common electrode.

Or, at least one of the second conductive regions 22 is used as a common electrode for electrically connecting the at least two corresponding first conductive regions 14. The at least two corresponding first conductive regions 14 and the at least two electrode soldering regions 13 corresponding to the at least two first conductive regions 14 may no longer be used as the common electrode.

As can be seen, in this embodiment, one or a plurality of LED chips may be arranged in one die bonding region according to demands. When the plurality of LED chips are arranged, the electrical connection relationship between the LED chips may be set flexibly according to specific demands so as to better satisfy various application scenarios, for example, better satisfy the scenario of backlight display or illumination or the like. In this embodiment, the corresponding relationship between the electrode soldering regions 13 and the first conductive regions 14 may be one-to-one correspondence or non-one-to-one correspondence. Similarly, the corresponding relationship between the first conductive regions 14 and the second conductive regions 22 and the corresponding relationship between the second conductive regions 22 and the third conductive regions 23 may also be flexibly set to one-to-one correspondence or non-one-to-one correspondence according to demands, which will not be described in detail.

It should be understood that in addition to the first substrate and the second substrate, the substrate in this embodiment may further include other substrates under the second substrate or between the first substrate and the second substrate, which will not be described in detail.

For the convenience of understanding, this embodiment will be described by taking a small-unit substrate obtained by cutting in units of the die bonding region shown as G1 in FIG. 1 as an example. Referring to FIG. 14, this small-unit substrate includes the first substrate 1 and the second substrate 2 which are stacked and fixed through the bonding layer 25. The front side of the first substrate 1 is provided with the electrode soldering regions 13, and the end of the first conductive members 12 in the first through holes located on the back side of the first substrate 1 form the first conductive regions. The front side of the second substrate 2 is provided with the corresponding second conductive regions 22, and the back side is provided with the corresponding third conductive regions 23. The second conductive regions 22 and the third conductive regions 23 are electrically connected through the second conductive members 24 in the second through holes 21. 21 in FIG. 14 may be complete through holes or grooves formed by cutting off a portion from the second through holes 21.

In this example shown in FIG. 14, the third conductive regions 23, the grooves and the second conductive members 24 located on the side walls of the grooves form pads for external electrical connection. During soldering, the solder, such as the solder paste, can retract into the grooves, thereby greatly reducing the space occupied by the solder and avoiding the short circuit formed between adjacent devices. It should be understood that the material of the solder in this embodiment can be selected flexibly. The "solder" in this embodiment means a binding layer finally formed by using a paste that is a mixture of metal powder, flux and organic matter. For example, the solder may include Sn and other metals. In an example, the solder may contain more than 50%, more than 60% or more than 90% of Sn, based on the total metal weight. For example, the solder may be a leadcontaining solder alloy, such as Sn-Pb or Sn-Pb-Ag, or a lead-free solder alloy, such as Sn-Ag alloys, Sn-Bi alloys, Sn-Zn alloys, Sn-Sb alloys or Sn-Ag-Cu alloys.

### Embodiment II:

In order to better protect the substrate, typically, a solder resist ink layer may be provided in the substrate, and the die bonding region on the substrate and the pad (i.e., the electrode soldering region in the present application) in the die bonding region are exposed outside the solder resist ink layer. During the manufacturing of the substrate, when the electrode soldering region is offset relative to the conductive layer (for example, copper foil layer) formed by the pad, the pad is offset relative to the die bonding region, which will lead to poor die bonding between electronic components such as LED chips and the pad and affect the product yield.

In view of the above problems, in this embodiment, a plurality of first locating structures are arranged around the pad in the die bonding region on the substrate, and a solder resist ink layer is arranged on the front side of the substrate. The solder resist ink layer includes a windowed region for exposing the pad, a plurality of hollowed regions for exposing the plurality of first locating structures, and a plurality of second locating structures located around the windowed region and spaced apart from the plurality of first locating structures. Through this structure, a coordinate of the die bonding region in a first direction is determined according to the plurality of second locating structures, and a coordinate of the die bonding region in a second direction is determined according to the plurality of first locating structures. The second direction is perpendicular to the first direction such that the die bonding region is located in the windowed region and covers the pad. In this way, the pad is located at the center of the die bonding region, thereby accurately locating the LED chip and improving the product yield.

The substrate in this embodiment may be, but not limited to, the substrate as shown in the above embodiment. In this case, the substrate further includes a solder resist ink layer and a plurality of first locating structures arranged on the front side of the first substrate 1 and located around the electrode soldering region 13, and the at least two electrode soldering regions 13 extend on the front side of the first substrate 1 along the first direction and are spaced apart.

The solder resist ink layer is arranged on the front side of the first substrate 1, and includes a windowed region for exposing the electrode soldering region 13, a plurality of hollowed regions for exposing the plurality of first locating structures and a plurality of second locating structures located around the windowed region and spaced apart from the plurality of first locating structures. Thus, a coordinate of the die bonding region in a first direction is determined according to the plurality of second locating structures, and a coordinate of the die bonding region in a second direction is determined according to the plurality of first locating structures. The second direction is perpendicular to the first direction such that the die bonding region is located in the windowed region and covers the electrode soldering region 13. Of course, it should be understood that the substrate in this embodiment may also be a substrate in other structures, such as a single-layer substrate or a composite structure substrate including more than three layers, which will not be described in detail.

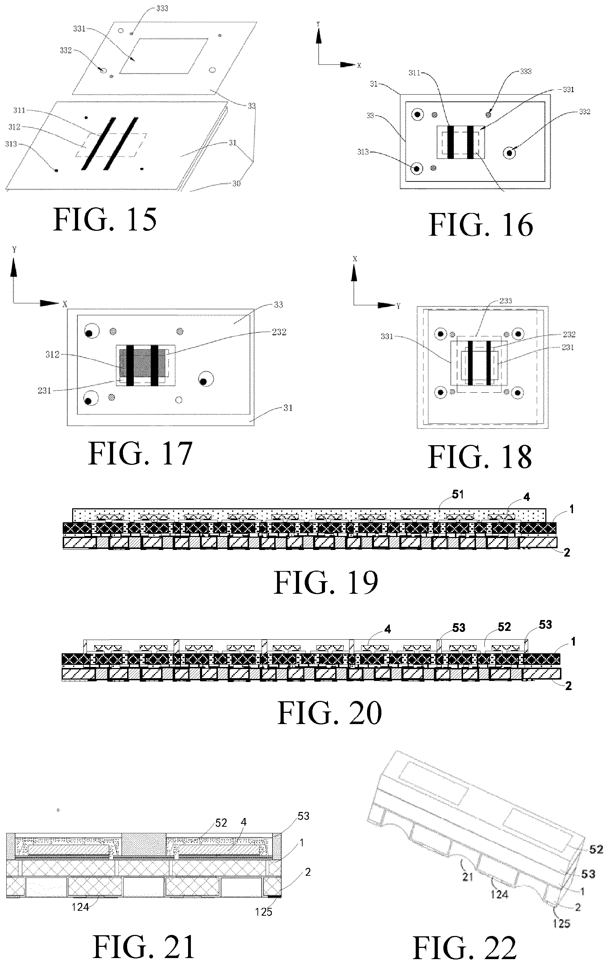

Referring to FIG. 15 to FIG. 17, the substrate 3 provided in this embodiment includes a substrate body 30, a copper foil layer 31 and a solder resist ink layer 33 arranged in a stacked manner. When the substrate 3 is the substrate in the above embodiment, the substrate body 30 may be the part of the substrate in the above embodiment excluding the electrode soldering regions, and FIG. 15 to FIG. 17 will be described by taking a region corresponding to a pair of electrode soldering regions 311 on the substrate in the above embodiment as an example.

The copper foil layer 31 in this embodiment is a thin and continuous metal foil formed by depositing a negative electrolytic material on the substrate body 30, which acts as a conductor of the substrate 3. The copper foil layer easily adheres to the insulating layer, accepts the printed protective layer, and forms a circuit pattern after etching. The copper foil layer 31 includes at least two electrode soldering regions 311 (i.e., pads) extending along a first direction X and spaced apart, and a plurality of first locating structures 313 arranged around the electrode soldering region 311. Besides, the substrate 3 further includes a die bonding region 312, and the electrode soldering region 311 is used for fixing an electronic component, such as an LED chip. The plurality of first locating structures 313 are used for locating the die bonding region 312.

The solder resist ink layer 33 is arranged on a surface of the copper foil layer 31 opposite to the substrate body 30 (that is, a front side of the copper foil layer 31), and has the functions of solder resistance, protection and improvement of insulation resistance. The solder resist ink layer 33 includes a windowed region 331, a plurality of hollowed regions 332 and a plurality of second locating structures 333. The windowed region 331 exposes the electrode soldering region 311 such that the electronic component is soldered onto the electrode soldering region 311, and thereby, the electronic component is arranged on the surface of the substrate 3 according to the preset position. Centers of the hollowed regions 332 coincide with centers of the first locating structures 313 to expose the first locating structures 313. Thus, it can be determined whether the solder resist ink layer 33 is offset relative to the copper foil layer 31 by observing the relative positions of the hollowed regions 332 and the first locating structures 313. When the centers of the hollowed regions 332 do not coincide with the centers of the first locating structures 313, it indicates that the solder resist ink layer 33 is offset relative to the copper foil layer 31. The plurality of second locating structures 333 are located around the windowed region 331 and spaced apart from the plurality of first locating structures 313.

In this embodiment, when the solder resist ink layer 33 is offset relative to the copper foil layer 31, if the die bonding region 312 is located by the first locating structures 313 or the second locating structures 333 alone, this will lead to an offset of the die bonding region 312, thereby leading to poor die bonding. As shown in FIG. 17, when the solder resist ink layer 33 is offset to the upper right relative to the copper foil layer 31, if the die bonding region 312 is located by the first locating structures 313, the position of the die bonding region 312 is shown as the rectangle 231 in the figure, and the electrode soldering region 311 is offset to the left relative to the die bonding region 312. If die bonding is performed in this case, at least a part of pins of the electronic component will be located on the solder resist ink layer 33, leading to poor die bonding caused by uneven heights of die bonding. When the die bonding region 312 is located by the second locating structures 333, the position of the die bonding region 312 is shown as the rectangle 232 in the figure. At this time, the electrode soldering region 311 is offset to the left relative to the windowed region 331. If soldering of the electronic component is performed in this case, the pins of the electronic component will be offset relative to the electrode soldering regions 311, thereby causing poor die bonding. In this embodiment, a coordinate of the die bonding region 312 in a first direction X is determined according to the plurality of first locating structures 313, and a coordinate of the die bonding region 312 in a second direction Y is determined according to the plurality of second locating structures 333. The second direction Y is perpendicular to the first direction X. The obtained die bonding region 312 is shown as the dashed area in the figure. At this time, the die bonding region 312 is located in the windowed region 331 and covers the two electrode soldering regions 311, and the electrode soldering regions 311 are located at the center of the die bonding region 312. In this way, when die bonding is performed on the electronic component, the range of drift of the electronic component on the electrode soldering region 311 can be limited, and the amplitude of drift can be reduced, thereby accurately locating the electronic component.

By arranging the first locating structures 313 and the second locating structures 333 respectively on the copper foil layer 31 and the solder resist ink layer 33, when the solder resist ink layer 33 is offset relative to the copper foil layer 31, the coordinate of the die bonding region 312 along the first direction X can be determined according to the first locating structures 313, and the coordinate of the die bonding region 312 along the second direction Y can be determined according to the second locating structures 333, so that the electrode soldering region 311 can be located at the center of the die bonding region 312, thereby accurately locating the electronic component and improving the product yield.

In some examples of this embodiment, the numbers of the first locating structures 313 and the second locating structures 333 may be three each. In this embodiment, the electrode soldering regions 311 include a first electrode soldering region and a second electrode soldering region. The first locating structures 313 include a locating structure I, a locating structure II and a locating structure III. The locating structure I and the locating structure II are arranged along the Y-axis direction. Connecting lines of the locating structure III, the locating structure I and the locating structure II form a triangle, and a distance of the connecting line of the locating structure III and the locating structure I and a distance of the connecting line of the locating structure III and the locating structure II are greater than a distance of the connecting line of the second electrode soldering region and first locating structure and a distance of the connecting line of the second electrode soldering region and the first locating structure II, so that the first electrode soldering region and the second electrode soldering region are both located between the locating structure III and the locating structure II.

Similarly, the second locating structures 333 include a locating structure IV, a locating structure V and a locating structure VI. The locating structure IV and the locating structure V are arranged around the windowed region along the Y-axis direction. The locating structure IV and the locating structure V are arranged on a same side of the windowed region 331. The locating structure VI is arranged on a side of the windowed region away from the locating structure IV and the locating structure V along the first direction X. It can be understood that the way of locating the die bonding region by the second locating structures is the same as that by the first locating structures. By setting the numbers of the first locating structures and the second locating structures to be three each, the position and size of the die bonding region in the first direction X and the second direction Y can be determined. Moreover, this layout of locating structures is simple and easy to process.

It can be understood that in other embodiments, the numbers of the first locating structures and the second locating structures may also be more than 3 each, which depends on the specific application demands.

In some examples of this embodiment, the pattern formed by the connecting lines formed by sequentially connecting the plurality of first locating structures 313 is a non-regular polygon, and a maximum distance between the plurality of first locating structures 313 along the first direction X is not equal to a maximum distance along the second direction Y The offset of the solder resist ink layer 33 relative to the copper foil layer 31 includes both offsets along the first direction X and the second direction Y and a rotational offset, which means the solder resist ink layer 33 rotates by a certain angle relative to the copper foil layer 31, such that the electrode soldering region 311 is partially covered by the ink layer 30, affecting the die bonding. If the pattern formed by the connecting lines formed by sequentially connecting the plurality of first locating structures 313 and formed by the connecting lines formed by sequentially connecting the plurality of second locating structures 333 is a regular polygon, such as a regular triangle and a square, or the maximum distance between the plurality of first locating structures 313 along the first direction X is equal to the maximum distance along the second direction Y, forming an isosceles right triangle, after the solder resist ink layer 33 is rotationally offset by a certain angle relative to the copper foil layer 31, the plurality of first locating structures 313 after rotation still coincide with the plurality of first locating structures 313 before the offset, so that the centers of the plurality of hollowed regions 332 can still coincide with the centers of the plurality of first locating structures 313. In this case, it is difficult to determine whether the solder resist ink layer 33 is offset relative to the copper foil layer 31.

The following is an example in which the pattern formed by the connecting lines formed by sequentially connecting the plurality of first locating structures 313 and formed by the connecting lines formed by sequentially connecting the plurality of second locating structures 333 is a square. When the solder resist ink layer 33 is not offset relative to the copper foil layer 31, the die bonding region 312 determined according to the first locating structures 313 and the second locating structures 333 jointly is shown as the rectangle 231 in FIG. 18. When the solder resist ink layer 33 is rotationally offset by 90 degrees relative to the copper foil layer 31, the centers of the plurality of hollowed regions 332 still coincide with the centers of the plurality of first locating structures 313 (that is, the center of the hollowed region 332 coincides with the center of the corresponding first locating structure 313), and at this time, the position of the windowed region 331 relative to the copper foil layer 31 is shown as the rectangle 233 in FIG. 18. By setting the pattern formed by the connecting lines formed by sequentially connecting the plurality of first locating structures 313 and the plurality of second locating structures 333 to be a non-regular polygon and the maximum distance between the plurality of first locating structures 313 along the first direction X to be not equal to the maximum distance along the second direction Y, if the solder resist ink layer 33 is rotationally offset relative to the copper foil layer 31, the offset can be determined quickly, and thereby, the locating of the die bonding region 312 can be adjusted.

In this embodiment, referring to FIG. 16, when the centers of the hollowed regions 332 coincides with the centers of the first locating structures 313, the coordinates of the die bonding region 312 in the first direction X and the second direction Y are determined according to the plurality of first locating structures 313 or the plurality of second locating structures 333. For example, after the solder resist ink layer 33 is arranged on the copper foil layer 31, the hollowed region 332 is arranged on the solder resist ink layer 33 in the position corresponding to the first locating structure 313, so as to visually determine whether the solder resist ink layer 33 is offset relative to the copper foil layer 31. When the hollowed regions 332 coincide with the first locating structures 313, the solder resist ink layer 33 is not offset relative to the copper foil layer 31. At this time, the coordinate of the die bonding region 312 in the first direction X can be determined according to the first locating structures 313, and the coordinate of the die bonding region 312 in the second direction Y can also be determined according to the first locating structures 313. Moreover, the die bonding region 312 determined according to the first locating structures 313 is located at the center of the windowed region 331, and the electrode soldering regions 311 are located at the center of the die bonding region 312. Similarly, when the centers of the hollowed regions 332 coincide with the centers of the first locating structures 313, both the coordinate of the die bonding region 312 in the first direction X and the coordinate of the die bonding region 312 in the second direction Y can be determined according to the second locating structures 333. Moreover, the die bonding region 312 determined according to the second locating structures 333 is located at the center of the hollowed region 332, and the electrode soldering regions 311 are located at the center of the die bonding region 312. At this time, the die bonding regions 312 determined according to the first locating structures 313 and the second locating structures 333 coincide, and the electronic component can be accurately fixed to the substrate 3.

In an example of this embodiment, the die bonding region 312 is in the shape of a rectangle, and the windowed region 331 is in the shape of a corresponding rectangle. The shape of the windowed region 331 matches the shape of the die bonding region 312, so that most of the electronic components can be well fixed with the electrode soldering regions 311 and are less likely to drift. It can be understood that due to the diversity of electronic components and different distribution of pins, the die bonding region 312 and the windowed region 331 may also be in the shape of other arbitrary polygons.

In an example of this embodiment, the size of the windowed region 331 corresponds to the size of the electronic component. When the solder resist ink layer 33 covers the copper foil layer 31, since the windowed region 331 exposes the electrode soldering regions 311, the electronic component can be soldered to the corresponding position on the substrate 3. When the electronic component has a large size, there is a large distance between soldering pins on the electronic component, and accordingly, the electrode soldering regions 311 have a large area and a large spacing distance therebetween. By designing the size of the windowed region 331 to correspond to the size of the electronic component, the electrode soldering regions 311 corresponding to the electronic component can be completely located at the center of the windowed region 331, thereby ensuring the electronic component to be well fixed to the substrate 3 and improving the product yield.

In an example of this embodiment, the hollowed region 332 may be in the shape of a circle, a square, a cross, etc. For example, in a case that the hollowed region 332 is in the shape of a circle, it can be determined whether the solder resist ink layer 33 is offset relative to the copper foil layer 31 by determining whether the first locating structure 22 is located at the center of the circular hollowed region 332, which thereby makes the determination process simple and quick.

In an example of this embodiment, the first locating structures 313 may also be in the shapes of circles, squares and crosses, which are not limited thereto. For example, in a case that the first locating structures 313 are circular locating points, the locating may be realized according to the centers of the circular locating points, so that the die bonding region 312 can be located more accurately. It can be understood that in other embodiments, the shape of the first locating structures 313 may be adjusted according to the size, the circuit pattern layout and the aesthetics of the substrate 3, and the first locating structures 313 and the hollowed regions 332 may be in the shapes of a combination of any shapes, as long as the hollowed regions 332 can expose the centers of the first locating structures 313. For example, while the first locating structures 313 are in the shape of squares, the hollowed regions 332 are in the shape of circles.

In some examples of this embodiment, when the back side of the substrate 3 is provided with the die bonding region, the die bonding region on the back side may also be located by using the locating structures arranged on the front side of the substrate, which will not be described in detail.

### Embodiment III:

This embodiment provides a manufacturing method for the substrate in the above embodiment, including:
At least two electrode soldering regions and at least two corresponding first conductive regions are formed respectively on a front side and a back side of a first substrate by a gold plating process, and at least two corresponding second conductive regions and at least two corresponding third conductive regions are formed respectively on a front side and a back side of a second substrate by a gold plating process; first through holes communicating the electrode soldering regions with the corresponding first conductive regions and second through holes communicating the second conductive regions with the corresponding third conductive regions are provided respectively in the first substrate and the second substrate, and first conductive members and second conductive members are formed respectively in the first through holes and the second through holes.

The back side of the first substrate is aligned and bonded to the front side of the second substrate, and the first conductive regions are electrically connected to the corresponding second conductive regions.

In some examples of this embodiment, when the first conductive regions and the corresponding second conductive regions realize reliable electrical connection through the conductive adhesive layer, before the back side of the first substrate is aligned and bonded to the front side of the second substrate, the method may further include arranging a conductive adhesive layer between the first conductive regions and the corresponding second conductive regions.

In some examples of this embodiment, when the first substrate and the second substrate are arranged in a stacked manner through a bonding layer, before the aligning and bonding the back side of the first substrate to the front side of the second substrate, the method may further includes at least one of the following steps:
arranging a first bonding layer on the back side of the first substrate and in a region other than the first conductive regions; and
arranging a second bonding layer on the front side of the second substrate and in a region other than the second conductive regions.

For the convenience of understanding, this embodiment will illustrate a specific manufacturing process of the substrate, including:
S201: Providing a first substrate and a second substrate. The first substrate is formed with a die bonding region for performing die bonding on an LED chip.

In addition, it should be understood that in this embodiment, the number of LED chips arranged in each die bonding region may be the same or different, or the numbers of LED chips arranged in at least a part of the die bonding regions may be the same and the numbers of LED chips arranged in the rest die bonding regions may be different.

S202: Forming first through holes in each die bonding region of the first substrate.

It should be understood that in this embodiment, the first through holes in the first substrate may be formed by various perforation methods, for example, but not limited to, drilling, etching, etc.

S203: Forming electrode soldering regions in each die bonding region of the first substrate by a gold plating process, forming first conductive regions corresponding to the electrode soldering regions on the back side of the first substrate by a gold plating process, and forming first conductive members in the first through holes that electrically connects the electrode soldering regions in each die bonding region to the corresponding first conductive regions.

It should be understood that in this embodiment, the first conductive members may be formed before the electrode soldering regions and/or the first conductive regions are formed on the first substrate, and after the first conductive members are formed, the electrode soldering regions and the corresponding first conductive regions are formed respectively on the front side and the back side of the first substrate. The first conductive members may also be formed during the process of forming the electrode soldering regions and/or the first conductive regions on the first substrate.

It should be understood that in this embodiment, the electrode soldering regions and the corresponding first conductive regions formed on the first substrate may be formed respectively by different process steps, or directly in one process step. For example, in an example, the electrode soldering regions may be formed on the front side of the first substrate before the first conductive regions are formed on the back side of the first substrate, or the first conductive regions may be formed on the back side of the first substrate before the electrode soldering regions are formed on the front side of the first substrate, or the electrode soldering regions and the corresponding first conductive regions are directly formed at the same time in one process step.

It should be understood that in this embodiment, the specific gold plating process for forming the electrode soldering regions and the corresponding first conductive regions is not limited, as long as the electrode soldering regions and the corresponding first conductive regions can be formed reliably. It should be also understood that in this embodiment, the process of forming the electrode soldering regions and the corresponding first conductive regions is not limited to the gold plating process, and may also be other equivalent substitutions. For example, the electrode soldering regions and the corresponding first conductive regions may also be formed by, but not limited to, deposition, which will not be described in detail.

Optionally, in an example of this embodiment, in order to improve the soldering effect and performance between the electrode soldering regions and the LED chip, the forming the electrode soldering regions on the first substrate may include, but not limited to:
S301: Forms a first copper coating on the front side of the first substrate.
S302: Forms a first nickel coating on the first copper coating.
S303: Forms a first gold coating on the first nickel coating.
S204: Forms a second through hole in the second substrate.

It should be understood that in this embodiment, the second through holes in the second substrate may be formed by various perforation methods, for example, but not limited to, drilling, etching, etc.

S205: Forming second conductive regions corresponding to the first conductive regions on the front side of the second substrate by a gold plating process, form third conductive regions corresponding to the second conductive regions on the back side of the second substrate by a gold plating process, and form second conductive members electrically connecting the second conductive regions and the corresponding third conductive regions on side walls of the second through holes.

The second conductive members may be formed only on the side walls of the second through holes (may completely or partially cover the side walls of the second through holes) and do not fully fill the second through holes, so that the remaining spaces of the second through holes can be used for containing the solder paste during the soldering process, and the third conductive regions and the second through holes together form internal pads. This can further reduce the spacing between the adjacent LED chips or LED light beads, improve the color mixing effect and narrow the bezel of the display screen manufactured with this substrate. It should be understood that in this embodiment, the second conductive regions and the corresponding third conductive regions formed on the second substrate may be formed respectively by different process steps, or directly in one process step. For example, in an example, the second conductive regions may be formed on the front side of the second substrate before the third conductive regions are formed on the back side of the second substrate, or the third conductive regions may be formed on the back side of the second substrate before the second conductive regions are formed on the front side of the second substrate, or the second conductive regions and the corresponding third conductive regions are directly formed at the same time in one process step.

It should be understood that in this embodiment, the specific gold plating process for forming the second conductive regions and the corresponding third conductive regions is not limited, as long as the second conductive regions and the corresponding third conductive regions can be formed reliably. It should be also understood that in this embodiment, the process of forming the second conductive regions and the corresponding third conductive regions is not limited to the gold plating process, and may also be other equivalent substitutions. For example, the second conductive regions and the corresponding third conductive regions may also be formed by, but not limited to, deposition, which will not be described in detail.

In an example of this embodiment, in order to improve the soldering effect and performance between the third conductive regions and an external circuit board or other objects, the forming the third conductive regions on the second substrate may include, but not limited to:
S401: Forming a second copper coating on the back side of the second substrate.
S402: Forming a second nickel coating on the second copper coating.
S403: Forming a second gold coating on the second nickel coating.
S206: Forming a first bonding layer and/or a second bonding layer on the back side of the first substrate in a region other than the first conductive regions and/or on the front side of the second substrate in a region other than the second conductive regions.
S207: Algining and bonding the first substrate to the second substrate through the bonding layer, and then electrically connecting the first conductive regions to the corresponding second conductive regions.

For the convenience of further understanding, the following description will take a specific manufacturing process of the substrate as an example, which may include the manufacturing process of the substrate. The manufacturing process includes, but not limited to:
S501: Providing a first substrate and a second substrate, and respectively cleaning the first substrate and the second substrate.
S502: Making through holes having diameters of 0.075 mm in the raw first substrate according to designed positions (and in each die bonding region) by drilling.
S503: Making second through holes having diameters of 0.3 mm in the raw second substrate according to designed positions by drilling.
S504: Embedding copper pillars or conductive pillars of other metals into the through holes of the first substrate.
S505: Performing copper electroplating on the first substrate to further fill the through holes until the through holes are fully filled.
S506: Flattening the front side and the back side of the first substrate by polishing, especially positions of the through holes.
S507: Forming, after the flattening, electrode soldering regions and corresponding first conductive regions respectively on the front side and the back side of the substrate through circuits. In this example, both the electrode soldering regions and the first conductive regions are copper layers, and after the electroplating, the through holes of the first substrate embedded in the first substrate to form solid copper pillars.
S508: Electroplating Cu layers respectively in corresponding positions on the front side and the back side of the second substrate to form second conductive regions and corresponding third conductive regions. During this process, the Cu layers are deposited on inner walls of the second through holes to form the second conductive members.
S509: Applying a conductive adhesive uniformly between the first conductive regions on the back side of the first substrate and the second conductive regions on the front side of the second substrate, and apply an adhesive uniformly to the first conductive regions and a region other than the regions where the conductive adhesive is located on the back side of the first substrate, and/or to the second conductive regions and a region other than the regions where the conductive adhesive is located on the front side from the second substrate.
S510: Aligning the first substrate with the second substrate through alignment holes or through alignment holes and alignment protrusions at corners, and bonding the first substrate to the second substrate with a bonding accuracy of ±5 µm. After the bonding, the copper pillars in the through holes and the second conductive members in the corresponding second through holes are electrically connected.
S511: Optionally, sequentially plating Cu layers, Ni layers and Au layers respectively on the electrode soldering regions on the front side and the third conductive regions on the back side of the substrate.
S512: Printing corresponding positions on the back side of the second substrate with a white legend and a green solder resist, and perform baking.

As can be seen, the manufacturing process of the substrate provided in this embodiment is simple and efficient, and low in cost. Moreover, in the manufacturing process, the mature technique of making through holes in the single-layer substrate is performed first, and then the first substrate and the second substrate are bonded simply to form the double-layer substrate structure, which greatly lowers the requirements for high-precision equipment and the threshold of the encapsulation technique. Any company having liquid adhesive molding equipment and technique is capable of industrial production of the manufacturing process.

### Embodiment IV:

This embodiment further provides an LED light source assembly manufactured by using the substrate in the above embodiment. The LED light source assembly includes the substrate in the above embodiment, and further includes LED chips arranged in die bonding regions on the substrate. Positive and negative electrodes of the LED chips are respectively electrically connected to the corresponding electrode soldering regions in the die bonding regions by, but not limited to, soldering with a solder or bonding with a conductive adhesive. It should be understood that the LED light source assembly in this embodiment can be used as a display assembly for display purposes, or as an illuminator assembly for illumination purposes, or as an indicator assembly for indication purposes.

In some examples of this embodiment, the LED light source assembly further includes a capsule. The capsule covers the LED chip, thereby protecting the LED chip. It should be understood that the structure of the capsule in this embodiment can be set according to application demands. For the convenience of understanding, this embodiment provides several capsule structures as examples.

Example I: The capsule in this example includes a first encapsulating adhesive layer arranged on a front side of a first substrate and covering the LED chips. For example, referring to FIG. 19, the LED light source assembly includes a plurality of LED chips 4 arranged on the first substrate 1. In this example, the LED chips 4 are flip chips. In other embodiments, the LED chips 4 may also be normal chips or vertical chips with corresponding structures so as to be electrically connected to corresponding electrode soldering regions. The LED light source assembly further includes a first encapsulating adhesive layer 51 arranged on the first substrate 1 and covering the LED chips 4. In this example, the first encapsulating adhesive layer 51 may be a transparent adhesive layer or a translucent adhesive layer. In some examples, the first encapsulating adhesive layer 51 may include, but not limited to, at least one of light conversion particles (e.g. phosphor) and diffusion particles. In some application scenarios, the first encapsulating adhesive layer 51 may be a single-layer adhesive structure or a composite-layer structure. For example, the first encapsulating adhesive layer 51 may include at least two of a transparent adhesive layer or translucent adhesive layer, a silver adhesive layer and a quantum dot film layer.

Example II: The capsule in this example includes an encapsulating adhesive unit arranged on a front side of a first substrate and covering the die bonding regions and the LED chips in the die bonding regions, and a first reflective adhesive layer arranged on the front side of the first substrate and enclosing the encapsulating adhesive unit. For example, referring to FIG. 20, the LED light source assembly includes a plurality of LED chips 4 arranged on the first substrate 1, and further includes an encapsulating adhesive unit 52 arranged on the first substrate 1 and covering the LED chips 4. In this example, the material and structure of the encapsulating adhesive unit 52 may be, but not limited to, those of the first encapsulating adhesive layer 51 in the above example, and will not be described in detail. The capsule further includes a first reflective adhesive layer 53 arranged on the front side of the first substrate 1 and enclosing the encapsulating adhesive unit 52. The reflective adhesive layer in this embodiment can be realized by, but not limited to, a white wall adhesive, a black adhesive or a translucent adhesive. The enclosing may be performed in units of individual LED chips, or in units of individual die bonding regions, or in units of multiple die bonding regions according to demands, or all die bonding regions on the front side are enclosed by one first reflective adhesive layer 53 as a whole, which depends on the specific demands. In this example, the arrangement of the first reflective adhesive layer 53 can further improve the light emitting efficiency of the LED chips. When the LED light source assembly shown in FIG. 20 is used for display or illumination purposes, the first reflective adhesive layer 53 can prevent optical crosstalk between the LED chips in the adjacent encapsulating adhesive units 52, which can further improve the display and illumination effects.

It should be understood that the LED light source assemblies in Example I and Example II are undiced complete-board light source assemblies. In this embodiment, the complete-board light source assembly may be diced according to demands to obtain small LED light source units, and one LED light source unit may be used as one light bead or one display unit. For example, referring to FIG. 21 and FIG. 22, FIG. 22 and FIG. 21 show three-dimensional views of the LED light source unit. This LED light source unit includes the substrate including the first substrate 1 and the second substrate 2 as described in the above example, and further includes the LED chips 4 arranged in the die bonding regions. In this example, the LED chips 4 are normal LED chips, and the adjacent LED chips 4 use one common electrode soldering region to form series connection, which, of course, may be parallel connection or series and parallel connection. The LED light source unit further includes an encapsulating adhesive unit 52 and a first reflective adhesive layer 53 enclosing the encapsulating adhesive unit 52. In FIG. 21, the first reflective adhesive layer 53 between the adjacent LED chips may be removed or retained according to demands. The retained first reflective adhesive layer can prevent optical crosstalk between the adjacent LED chips, which can further improve the illumination or display effects. As shown in FIG. 22, the symbol 21 shows grooves formed by cutting the second through holes 21 in the second substrate 2. These grooves can contain the solder during the soldering process, which greatly reduces the space occupied by the solder. This can increase the soldering area, improve the soldering reliability and reduce the spacing set between adjacent chips or devices. In this example, a white legend layer 124 and a green solder resist layer 125 may also be arranged respectively in corresponding positions on the back side of the second substrate 2, so as to better protect the LED light source assembly.

### Example III:

The capsule in this example includes lens caps arranged on the front side of the first substrate and covering the LED chips, and a second reflective adhesive layer arranged on the front side of the first substrate and enclosing the lens caps. Since the lens caps cover the LED chips, the lens caps can focus light emitted by the LED chips to some extent, thereby increasing the brightness of light emitted from the LED chips. This increases the display brightness and color purity of the LED light source module on the basis of not changing the driving current. Moreover, the peripheries of the lens caps are enclosed by a second reflective adhesive layer. On the one hand, the second reflective adhesive layer can reduce mutual interference of light between the LED chips. On the other hand, light emitted by the LED chips is reflected by the second reflective adhesive layer, so that all the light of the LED chips can exit from a light-exiting surface, which further increases the display brightness and color purity of the LED light source module and improves the display effect of the light emitting module.

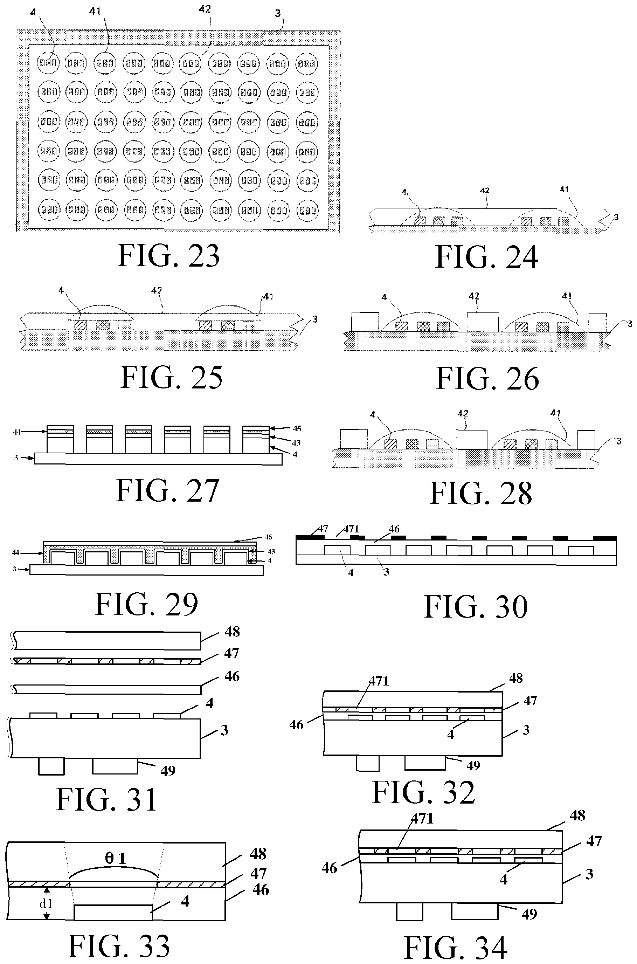

For the convenience of understanding, this example will be described below in conjunction with the structure of a specific LED light source assembly. FIG. 23 shows a schematic top view of the LED light source assembly. The LED light source assembly includes a substrate 3 (this substrate 3 may be the substrate in the above embodiment, or a substrate in other structures), a plurality of LED chips 4, a plurality of lens caps 41 and a second reflective adhesive layer 42.

In the current display industry, all LED light source assemblies usually support color display. Therefore, one pixel in the LED light source assembly supports emission of red light, green light and blue light. As a result, in this example, at least a part of the plurality of LED chips 4 can emit red light, at least a part can emit green light, and the rest part can emit blue light. In this example, the LED chips 4 include blue light LED chips, red light LED chips and green light LED chips. For example, the blue light LED chips and the green light LED chips may be gallium nitride-based LED chips, and the red light LED chips may be gallium arsenide-based LED chips. In other examples, all the LED chips 4 in the LED light source assembly may be blue light LED chips. In order to enable a part of the LED chips to respectively emit green light and red light, corresponding light conversion layers may be arranged on the light-exiting surfaces of the LED chips 4. It should be understood that the above only describes the case in which one pixel supports emission of red, green and blue light, but in some examples, in addition to the red, green and blue light, the LED chips 4 at one pixel can also emit at least one of cyan light, white light and yellow light. In this embodiment, a set of LED chips arranged at one pixel is called a light emitting unit. Therefore, in some examples of this embodiment, one light emitting unit includes three LED chips 4, but in other examples, one light emitting unit may include more LED chips.

In this example, the LED chips 4 are covered with the lens caps 41. In some examples, one lens cap 41 only covers one LED chip 4. In this case, the lens caps 41 are arranged in units of LED chips 4, and the lens caps 41 are in one-to-one correspondence to the LED chips 4. Accordingly, one light emitting unit corresponds to at least three lens caps 41. In other examples, at least two LED chips 4 may be included in one lens cap 41. For example, in one example, three LED chips 4 in one light emitting unit in the LED light source assembly are respectively covered by different lens caps 41. In still other examples, the lens caps 41 are arranged in units of light emitting units. In this case, the light emitting units are in one-to-one correspondence to the lens caps 41. Accordingly, one lens cap 41 covers at least three LED chips at the same time. For example, in a case that one lens cap 41 covers a first LED chip, a second LED chip and a third LED chip at the same time, all the three LED chips may be blue light LED chips, and light-exiting surfaces of two of the LED chips are provided with a light conversion layer. The three LED chips may also be a red light LED chip, a green light LED chip and a blue light LED chip respectively. However, in any case above, the light emitted by the three LED chips into the lens cap 41 is red light, green light and blue light respectively.

In this example, the lens caps 41 may completely wrap the LED chips 4 covered by them together with the substrate 3, for example, as shown in FIG. 24. In other examples, the LED chips 4 may be partially exposed outside the lens caps 41, for example, as shown in FIG. 25. However, even if the lens caps 41 and the substrate 3 are incapable of completely wrapping the LED chips 4, the lens caps 41 covering the LED chips 4 in this embodiment also requires that the lens caps 41 cover at least the light-exiting surfaces on the top surface of the LED chips 4.

In this example, a height of center regions of the lens caps 41 are greater than or equal to heights of edge regions. It should be understood that the "height" direction in this embodiment refers to a direction perpendicular to the substrate 3, with the surface of the substrate 3 as the base surface. Therefore, the height of a certain position of a lens cap 41 refers to a distance from this position to the surface of the substrate 3. The heights of the center regions of the lens caps 41 are greater than or equal to the heights of the edge regions, so the lens caps 41 can focus light emitted by the LED chips 4 covered thereby to some extent. When viewed from the outside, the lens caps 41 can increase the brightness of the LED chips 4. Thereby, the display brightness and color purity of the LED light source assembly can be increased to some extent on the basis of not changing the driving current, thereby improving the user's visual experience.

In this example, the heights of the center regions of the lens caps 41 are equal to the heights of the edge regions. For example, the profile of the longitudinal sections of the lens caps 41 may be in the shape of rectangles. In some application scenarios, the heights of the lens caps 41 decrease stepwise from the centers to the peripheries. When the cross sections of the lens caps 41 are in the shape of circles, the overall lens caps 41 each include two or more coaxial cylinders, and the smaller the radiuses of the cross sections of the cylinders, the larger the heights. Of course, in other examples, the cross sections of the lens caps 41 may also be in the shape of rectangles. In some application scenarios, the center regions of the lens caps 41 are flat surfaces (i.e., the heights of the center regions are the same everywhere), but the heights of the edge regions gradually decrease. At this time, the longitudinal sections of the lens caps 41 are in the shape of trapezoids.

In some application scenarios in this example, the heights of the lens caps 41 gradually decrease from the centers to the peripheries with no abrupt change. In this case, the profile of the longitudinal sections of the lens caps 41 can be in the shape of triangles or arcs. When at least a part of the profiles of the longitudinal sections of the lens caps 41 are in the shape of arcs, the lens caps are convex lenses, which have a stronger ability to focus light than the case in which the heights of the center regions are equal to the heights of the edge regions. Optionally, in an example, the profiles of the longitudinal sections of the lens caps 41 each include a line segment and an arc connecting two ends of the line segment; or the profiles of the longitudinal sections of the lens caps 41 each include three line segments and an arc, and these line segments and the arc are connected end to end to form the profiles of the longitudinal sections of the lens caps 41.

In this example, there may be a gap between the adjacent lens caps 41. For example, referring to FIG. 24, a second reflective adhesive layer 42 is arranged in the gap. The second reflective adhesive layer 42, which is formed by curing a white adhesive, a black adhesive or the like, is attached to the surface of the substrate 3. It can be understood that the second reflective adhesive layer 42 arranged between the adjacent lens caps 41 can prevent light emitted from one lens cap 41 from entering another lens cap 41 to some extent, thereby preventing the mutual interference of light in the adjacent lens caps 41 from affecting the display effect of the LED light source assembly. It can be understood that within a certain range, the effect of the second reflective adhesive layer 42 on preventing the mutual interference of light is positively correlated with the height of the second reflective adhesive layer, i.e., the higher the second reflective adhesive layer 42 in the gap, the more the second reflective adhesive layer 42 can isolate light from the two sides. However, the second reflective adhesive layer 42 cannot be infinitely high. This will affect the thickness of the LED light source assembly. Moreover, after the height of the second reflective adhesive layer 42 exceeds a certain range, it makes no sense to continue increasing it.

In this example, the height of the highest position of the second reflective adhesive layer 42 is greater than or equal to thicknesses of the LED chips 4, so the presence of the second reflective adhesive layer 42 can at least prevent at least a part of light emitted by the LED chips in one lens cap from entering the LED chips in another lens cap.

In this example, the second reflective adhesive layer 42 is arranged only in the gaps, and does not cover the lens caps 41, for example, as shown in FIG. 26. However, in other examples, for example, in FIG. 24 and FIG. 25, the second reflective adhesive layer 42 at least partially covers the lens caps 41, and the height of the highest position of the second reflective adhesive layer 42 is less than or equal to the heights of the highest positions of the lens caps 41. Since the heights of the centers of the lens caps 41 are the height of the highest positions of the lens caps 41, the height of the highest position of the second reflective adhesive layer 42 does not exceed the heights of the centers of the lens caps 41. In other words, the lens caps 41 are not completely covered by the second reflective adhesive layer 42, and at least the center regions of the lens caps 41 are not completely covered by the second reflective adhesive layer 42. When the second reflective adhesive layer 42 covers the lens caps 41 and their highest positions are at the same height, as shown in FIG. 24, the top surface of the second reflective adhesive layer 42 is tangent to the lens caps 41. In some cases, the height of the highest position of the second reflective adhesive layer 42 is less than the heights of the highest positions of the lens caps 41, as shown in FIG. 25.

In this example, the heights of the highest positions of the lens caps 41 may be 100 um to 200 um. For example, the heights of the highest positions of the lens caps 41 may be 100 um, 120 um, 155 um or 200 um.

Optionally, the height of the highest position of the second reflective adhesive layer 42 is 50 um to 200 um. For example, in an example, the height of the highest position of the second reflective adhesive layer 42 is 50 um, 100 um, 143 um or 200 um. It can be understood that the second reflective adhesive layer 42 can not only protect the LED chips in one lens cap from the interference of light emitted by the LED chips in other lens caps, but also, by using its reflection effect, make light emitted by the LED chips 4 in the lens caps 14 to centrally exit from the center regions of the lens caps 41 rather than from the edge regions of the lens caps 41, which can increase the brightness of light exiting from the lens caps 41.

In some application scenarios, the white adhesive for forming the second reflective adhesive layer 42 includes a heat dissipation material, such as boron trioxide or boric anhydride, which can improve the heat dissipation ability of the white adhesive, so that the second reflective adhesive layer 42 can transfer heat generated by the operation of the LED chips 4 in the lens caps 41 to the outside, thereby preventing the LED chips 4 from operating in a hot environment for a long time, which affects the performance of the LED chips 4.

In other application scenarios, the white adhesive includes an anti-yellowing material, such as ceramics. The second reflective adhesive layer 42 formed by the ceramics-containing white adhesive has a higher anti-yellowing effect, and can prevent the second reflective adhesive layer 42 from yellowing after operating for a long time and thus affecting the reflection effect of the second reflective adhesive layer 42.

It can be understood that the second reflective adhesive layer 42 may include both the heat dissipation material and the anti-yellowing material. For example, the white adhesive may be formed before the second reflective adhesive layer 42 is formed. In some examples of this embodiment, B203 and ceramics may be uniformly mixed with a base adhesive to obtain the white adhesive; and then, the second reflective adhesive layer 42 is formed from the white adhesive on the substrate 3 on which the LED chips 4 and the lens caps 41 have been arranged. In this case, the second reflective adhesive layer 42 has both excellent heat dissipation ability and anti-yellowing performance. Optionally, the base adhesive may include, but not limited to, at least one of resin, silicone, etc.

According to the LED light source assembly provided in this example, on the one hand, the lens caps cover the LED chips, and the heights of the center regions of the lens caps are not less than the height of the edge regions, so the lens caps can focus light emitted by the LED chips covered thereby to some extent. When viewed from the outside, the brightness of light emitted by the LED chips is increased. Thereby, the display brightness and color purity of the LED light source assembly are increased, and the display effect of the LED light source assembly is improved. On the other hand, the white adhesive wall is arranged in the gaps between the adjacent lens caps. The white adhesive wall can prevent LED light exiting from different lens caps from mutual interference. Moreover, for a lens cap, the white adhesive wall can, by using the reflection effect, prevent light emitted by the LED chips in the lens cap from exiting from the side surface of the lens cap, so that more light can exit from the top surface of the lens cap, thereby further improving the display brightness and color purity of the LED light source assembly.

### Example IV:

The traditional backlight structure needs a diffuser plate or a light guide plate to diffuse light from the light source. Due to the use of the light guide plate, the backlight structure has a large size, which makes the area and thickness of the light guide plate larger and increases the cost and weight of the backlight structure. Therefore, it is difficult for the traditional backlight structure to achieve low cost and light weight. As all the electronic products are developed to be lighter, thinner, shorter and smaller, how to reduce the overall thickness of the backlight structure to achieve ultrathin structure has become a difficult problem for major manufacturers to overcome.

The capsule in this example includes a third reflective adhesive layer arranged on the front side of the first substrate and covering at least front light-exiting surfaces of the LED chips, a diffusion layer arranged on the third reflective adhesive layer and a fourth reflective adhesive layer arranged on the diffusion layer. The front light-exiting surfaces of the LED chips are surfaces of the LED chips away from the first substrate. A part of light emitted by the LED chips can be reflected between a third reflective layer and a fourth reflective layer, so that the light emitted by the chips can be further dispersed, which makes the light exiting from the backlight structure softer. In this way, the light guide plate can be removed, so that the product can be made thinner in size and simpler in structure and have a better integrated structure, which is beneficial to reducing the cost.

For the convenience of understanding, this example will illustrate the LED light source assembly (which can be used as a display panel or a backlight in this example) below in conjunction with the accompanying drawings. As shown in FIG. 27, the LED light source assembly includes a substrate 3 and a plurality of LED chips 4 arranged on the substrate 3 and distributed in an array; and a third reflective layer 43 arranged on the LED chips 4. The third reflective layer 43 covers at least front light-exiting surfaces of the LED chips 4. The LED light source assembly further includes a diffusion layer 44 covering the third reflective layer 43, and a fourth reflective layer 45 arranged on the diffusion layer 44. In this example, the "cover" may be "partially cover" or "completely cover." For example, in FIG. 27, the third reflective layer 43 completely covers the front light-exiting surfaces of the LED chips 4, while the diffusion layer 44 covers an upper surface of the third reflective layer 43, and may not cover a side surface of the third reflective layer 43. Of course, the diffusion layer 44 may also completely cover the side surface of the third reflective layer 43 according to actual needs.

Light from the LED chips 4 enters the diffusion layer 44 through the third reflective layer 43, is diffused by the diffusion layer 44, goes to the fourth reflective layer 45 and exits through the fourth reflective layer 45. That is, in this example, a part of the light emitted by the LED chips 4 along the front light-exiting surfaces can directly penetrate the third reflective layer 43, the diffusion layer 44 and the fourth reflective layer 45 and exit through the fourth reflective layer 45. The rest of the light can be reflected at least once in a reflection mechanism formed between the third reflective layer 43 and the fourth reflective layer 45. Due to the presence of the diffusion layer 44, the angle of the reflected light may change. Thereby, this part of light is reflected a second time by the third reflective layer 43 to the diffusion layer, and then exits from the fourth reflective layer 45. Of course, there may still be a part of the light reflected twice that will be reflected three and even more times and eventually exit from the fourth reflective layer 45. The specific light propagation process is similar to the previous process, which further disperses the light emitted from the chips and makes the light exiting from the backlight structure softer. In practical applications, there may be no diffusion layer arranged on side light-exiting surfaces of the light emitting chips according to needs. If the diffusion layer does not include a luminescent conversion material, such as phosphor, then there is no diffusion layer arranged on the side light-exiting surfaces of the chips. If the diffusion layer contains a luminescent conversion material, such as phosphor, then there should be a diffusion layer arranged on the side light-exiting surfaces of the chips. This makes the chroma of the emitted light more uniform, and light from the diffusion layers on both the fronts and the sides of the chips is converted white light.

In an application scenario, the diffusion layer 44 includes a front diffusion region located directly above the front light-exiting surfaces of the LED chips 4, and a side diffusion region located between the adjacent LED chips. As another arrangement of the diffusion layer, as shown in FIG. 28, the diffusion layer 44 includes a front diffusion region arranged above the front light-exiting surfaces of the LED chips 4 and a side diffusion region arranged between the adjacent LED chips 4. In this example, the diffusion layer 44 may be the diffusion layer 44 applied on the upper surface of the third reflective layer 43 and filled in the gaps between the adjacent LED chips directly by spraying, which can improve the diffusion effect of the diffusion layer and further reduce the color mixing distance. The diffusion layer can be realized simply by the spraying process, so the manufacturing cost can be effectively reduced. In this application scenario, the fourth reflective layer 45 may be embedded in the diffusion layer 44, and the fourth reflective layer 45 is arranged on the diffusion layer 44 in the position corresponding to the third reflective layer 43. A coverage area of the fourth reflective layer 45 can be set according to actual needs. For example, the coverage area of the fourth reflective layer 45 may be greater than an area of the third reflective layer 43, and in the extreme case, the fourth reflective layer 45 completely covers the upper surface of the diffusion layer 44.

In an application scenario, a thickness of the third reflective layer 43 ranges from 10 µm to 30 µm, a thickness of the fourth reflective layer 45 ranges from 0 µm to 30 µm, and a thickness of the diffusion layer 44 ranges from 100 µm to 200 µm. In this example, through the design of the thicknesses of the first reflective layer, the diffusion layer and the second reflective layer, the ultrathin effect of a dot matrix backlight structure can be achieved. In an application scenario, the material of at least one of the third reflective layer 43 and the fourth reflective layer 45 includes a reflective material and an adhesive. The reflective material accounts for 5% to 15% of the adhesive mixture by weight. In this example, the reflective material may be titanium white, ceramics or the like. In this example, the reflective materials of the third reflective layer 43 and the fourth reflective layer 45 may be of different types. For example, the reflective material of the third reflective layer 43 is a mixture of titanium white and an adhesive, and the reflective material of the fourth reflective layer 45 is a mixture of ceramics and an adhesive. In this example, the mixture of the reflective material such as the titanium white and the ceramics with the adhesive can effectively reduce the cost and the complexity of the process.

In an application scenario, a material of the diffusion layer 44 includes a diffusion material and an adhesive. The diffusion material accounts for 5% to 30% of the adhesive mixture by weight. In this example, the diffusion material may be diffusion powder, and the diffusion powder may be doped with phosphor and mixed with the adhesive to obtain the material of the diffusion layer. In this example, the mixture of a conventional diffusion material and an adhesive can achieve the effect of reducing the color mixing distance. The conventional diffusion material is readily available and low in cost.

As another application scenario, the third reflective layer 43 may cover at least a part of the regions between the LED chips 4. As shown in FIG. 29, the gaps between the adjacent LED chips 4 on the substrate 3 are also covered with the third reflective layer 43. This can further reduce the complexity of the process and lower the input cost.

In addition, it should be understood that the specific structures of the third reflective layer 43, the diffusion layer 44 and the fourth reflective layer 45 described above are not limited to those shown in FIG. 27 to FIG. 29, and may also be other equivalent substitutions or combinations according to demands, which will not be described in detail.

### Example V:

In an LED display screen, the brightness and the contrast ratio play important roles in the display effect of the screen. For example, for a traditional mini-LED display module, a black component may be added to a colloid wrapping the light emitting device to form black adhesive encapsulation, which can improve the contrast ratio. The blacker the colloid, the higher the contrast. However, the black adhesive encapsulation also affects the brightness of the display module. While the contrast ratio is improved, the brightness will inevitably be lost correspondingly. The existing display module cannot have good brightness and contrast at the same time, which makes it difficult to further improve the effect of the display screen.

The LED light source assembly provided in this example includes a second encapsulating adhesive layer arranged on the front side of the first substrate and covering the LED chips and a light shielding layer arranged on the second encapsulating adhesive layer. The light shielding layer has light transmitting holes corresponding to the LED chips. While ensuring the contrast ratio, the brightness of the LED light source assembly is also ensured, so good brightness and contrast ratio can be achieved at the same time. Moreover, the viewing angle can be improved from many aspects, which is beneficial to ensuring the display effect.

In an application scenario of this example, the light shielding layer is a black target molecule layer obtained by depositing a black target through magnetron sputtering. For example, the LED light source assembly in an example, as shown in FIG. 30, includes a substrate 3, LED chips 4, a second encapsulating adhesive layer 46 covering the LED chips, and a light shielding layer 47 arranged on the second encapsulating adhesive layer 46. The light shielding layer 47 has light transmitting holes 471 corresponding to the LED chips 4. In this application scenario, the black target is deposited onto the surface of the second encapsulating adhesive layer 46 to form the light shielding layer 47, which may also be called a black matrix, through magnetron sputtering, so that a thin black matrix can be formed with high precision. The formed black matrix has low light transmittance, and ensures the light emitting effect and contrast ratio of the LED light source assembly. In this application scenario, the black target is a material for forming the black matrix, including, but not limited to, carbon black, metal light-absorbing materials and other materials that can effectively avoid light transmission.

In this application scenario, the magnetron sputtering, which is used to deposit the black target onto the second encapsulating adhesive layer 46 to form the black matrix, can make the thickness of the black target molecule layer very small. For example, in some implementation processes, the thickness of the black matrix formed by the magnetron sputtering can be 200 nm. However, the minimum thickness of the black matrix formed through traditional processes such as ink-jet printing, screen printing, spraying and coating is only about 50 µm. Moreover, the magnetron sputtering has high precision, so that the dimensional accuracy of the black matrix can be controlled to less than 10 nm. Besides, the black target molecule layer has compact molecular composition and low light transmittance, and can be made as black as possible. In some implementation processes, the light transmittance can be less than 5%. The smaller thickness of the black matrix ensures the light emitting angle of the LED light source assembly, the higher accuracy ensures the uniform appearance of the LED light source assembly and the uniformity of light emitted from the pixel, and the lower light transmittance ensures the contrast ratio of the LED light source assembly. It should be understood that the second encapsulating adhesive layer 46 in the above example may also be removed. In this case, the light shielding layer 47 may be directly arranged on the substrate 3.

In another application scenario of this example, the capsule further includes a third encapsulating adhesive layer arranged on the light shielding layer. In an example, as shown in FIG. 31 to FIG. 34, the LED light source assembly includes a substrate 3, LED chips 4, a light shielding layer 47, a second encapsulating adhesive 46 and a third encapsulating adhesive 48. The LED light source assembly further includes a driver unit 49 for driving the LED chips 4, which can be arranged on the other side of the substrate 3. The driver unit 49 includes, but not limited to, a driver chip and other devices. It can be understood that the second encapsulating adhesive 46 in this application scenario should be a light-transmitting transparent colloid and wrap the LED chips 4 so as to protect the LED chips 4 and other possible devices or structures on this side of the substrate 3. The light shielding layer 47 is arranged in a light emitting direction of the LED chips 4, for example, on the second encapsulating adhesive 46. The light shielding layer 47 includes light transmitting holes 471 for light to pass through. The light transmitting holes 471 of the light shielding layer 47 can allow the light to pass through, while the rest region of the light shielding layer 47 is not light-transmitting, which can prevent light between the LED chips 4 from mutual interference and optical crosstalk, thereby improving the contrast ratio of the LED light source assembly. The third encapsulating adhesive 48 is further arranged on the light shielding layer 47. The third encapsulating adhesive 48 can protect the light shielding layer 47.

In order to better understand the function of the light shielding layer 47 in this embodiment, referring to FIG. 32, the light shielding layer 47 is arranged in the light emitting direction of the LED chips 4, and the positions of the light transmitting holes 471 correspond to those of the LED chips 4. After the LED chips 4 emit light, the light is usually emitted within a certain angle range. Optical crosstalk of light from two LED chips 4 close to each other may occur in the location between the LED chips 4, and the light shielding layer 47 can effectively shield light in the region between the LED chips 4, which thereby avoids affecting the display effect of the LED light source assembly. The LED chips 4 and the light-transmitting holes 471 can be made as small as the process accuracy allows, so that the light shielding layer 47 has a larger non-light-transmitting region, which can further reduce the optical crosstalk. It can be understood that in the LED light source assembly of this embodiment, the non-light-transmitting region of the light shielding layer 47 can be made relatively black, to ensure the contrast ratio of the LED light source assembly to be as high as possible. Since the LED light source assembly of this embodiment uses the light transmitting holes 471 of the light shielding layer 47 to transmit light, the blackness of the non-light-transmitting region of the light shielding layer 47 does not affect the brightness of the LED light source assembly, and the light of the LED chips 4 can be fully emitted. As can be seen, while the contrast ratio of the LED light source assembly of this example is improved, the brightness is also ensured. In practical applications, there is no need to consider the balance between the contrast ratio and the brightness as in the traditional LED light source assembly. The non-light-transmitting region of the light shielding layer 47 in this example can be made as black as possible, so the contrast ratio can be greatly improved. Besides, since human eyes are less sensitive to low gray scale, the consistency of the ink color that is ultimately presented to the user by the LED light source assembly is greatly improved. A material of the light shielding layer 47 includes, but not limited to, carbon black, metal light-absorbing materials, etc. In some implementation processes, the carbon black and the metal light-absorbing material may be incorporated into a liquid epoxy resin. The light shielding layer 47 can be formed by means including, but not limited to, ink-jet printing, screen printing, spraying, coating, magnetron sputtering, etc. The centers of the light transmitting holes 471 of the light shielding layer 47 are aligned with the centers of the light emitting surfaces of the LED chips 4, and the areas of the light transmitting holes 471 are not less than the areas of the light emitting surfaces. If the light shielding layer 47 and the LED chips 4 are projected onto the substrate 3, the projections of the LED chips 4 are completely within the light transmitting holes 471 and at the centers of the light transmitting holes 471.

In some application examples, a thickness of the second encapsulating adhesive 46 is greater than heights of the LED chips 4, and the light shielding layer may 47 be arranged on the second encapsulating adhesive 46. The second encapsulating adhesive 46 includes, but not limited to, silicone or epoxy resin. The second encapsulating adhesive 46 is a material that is normally non-conductive. The light shielding layer 47 is arranged on the second encapsulating adhesive 46, and the carbon black, the metal light-absorbing material, etc. in the light shielding layer do not contact the LED chips 4, thereby avoiding short circuiting. There is a certain distance between the formed light shielding layer 47 and the LED chips 4, and the difference in this distance may affect the viewing angle. As shown in FIG. 33 and FIG. 34, the closer the light shielding layer 47 is arranged to the LED chips 4 (d1>d2), the greater the viewing angle (θ1>θ2). In some implementations, the second encapsulating adhesive 46 may be formed by molding. During the molding, the thickness of the second encapsulating adhesive 46 can be well controlled. After being molded onto the substrate 3, the second encapsulating adhesive 46 can be cured at high temperature. According to actual demands, for example, according to the demands for the viewing angle, the second encapsulating adhesive 46 can have any thickness. The viewing angle may also be improved by controlling the refractive index of the second encapsulating adhesive 46. Different materials of the second encapsulating adhesive 46 may lead to different refractive indexes. In some implementations, the refractive index of the second encapsulating adhesive 46 is not less than 1.5. For example, glass fiber with higher refractive index may be added to the epoxy resin to improve the viewing angle, or titanium dioxide nanoparticles may be added to improve the refractive index, which linearly increases according to the concentration of the doped material; or other methods may be used to control the refractive index of the second encapsulating adhesive 46. The larger the refractive index of the second encapsulating adhesive 46, the larger the viewing angle, and the smaller the light transmitting holes 471 in the light shielding layer 47 can be formed accordingly. The smaller the light transmitting holes 471, the higher the contrast ratio can be ensured. The viewing angle of the LED light source assembly is also affected by the thickness of the light shielding layer 47. Under the same conditions, the larger the thickness of the light shielding layer 47, the smaller the viewing angle. In some implementations, the thickness of the light shielding layer 47 is less than 10 µm, such as 1 µm, 3 µm, 5 µm, 8 µm, etc. As a preferred example, the thickness of the light shielding layer 47 may be 0.2 µm to 6 µm. In order to make the light shielding layer 47 thinner, the light shielding layer 47 may be formed by magnetron sputtering. For example, a mask, which shields the regions corresponding to the LED chips 4, is arranged on the second encapsulating adhesive 46. The material of the light shielding layer 47 is sputtered onto the encapsulating adhesive 46 by magnetron sputtering, and there will be no material of the light shielding layer 47 left in the regions corresponding to the LED chips 4 due to the shield of the mask, so the light transmitting hole 471 is formed. Then, the mask is removed to obtain the light shielding layer 47. It can be understood that the mask may be arranged in any form, and the magnetron sputtering process may be performed one or more times, as long as the desired light shielding layer 47 is formed. As can be seen, the viewing angle of the LED light source assembly of this embodiment can be improved by many approaches, and various parts in the LED light source assembly can be adjusted according to actual situations, which is beneficial to ensure a better display effect.

The third encapsulating adhesive 48 includes, but not limited to, silicone or epoxy resin, which may be the same as or different from the second encapsulating adhesive 46. In practical applications, the third encapsulating adhesive 48 may have any thickness. In a specific example, the thickness of the third encapsulating adhesive 48 may be selected adaptively to ensure a consistent total thickness of the LED light source assembly. During the manufacturing process, the thicknesses of other parts of the LED light source assembly may have a certain tolerance. The thickness of the third encapsulating adhesive 48 is adjusted according to the overall thickness required by the LED light source assembly to ensure the overall thickness accuracy of the LED light source assembly.

In some specific implementation processes, the second encapsulating adhesive 46 and/or the third encapsulating adhesive 48 may also be doped with other substances or a desired structure may be formed to achieve more display effects. Different materials or forming processes may also be selected for the third encapsulating adhesive 48 so as to form any one of the effects including matte, glossy, foggy and dull on its surface. In some implementation processes, the color of the third encapsulating adhesive 48 may be set to adjust the display effect. According to the LED light source assembly of this embodiment, the light shielding layer 47 is arranged in the light emitting direction of the LED chips 4 to improve the contrast ratio, and the light is transmitted through the light transmitting holes 471 in the light shielding layer 47, so the light transmittance is high. In practical applications, if there is a surplus of brightness of the LED light source assembly, a small amount of carbon black may be added to the second encapsulating adhesive 46 to further ensure the contrast ratio. In other implementation processes, reasonable selection of the refractive indices of the second encapsulating adhesive 46 and the third encapsulating adhesive 48 leads to a smooth transition of refractive indices between the LED chips 4, the second encapsulating adhesive 46 and the third encapsulating adhesive 48, which can ensure the overall light transmittance of the LED light source assembly.

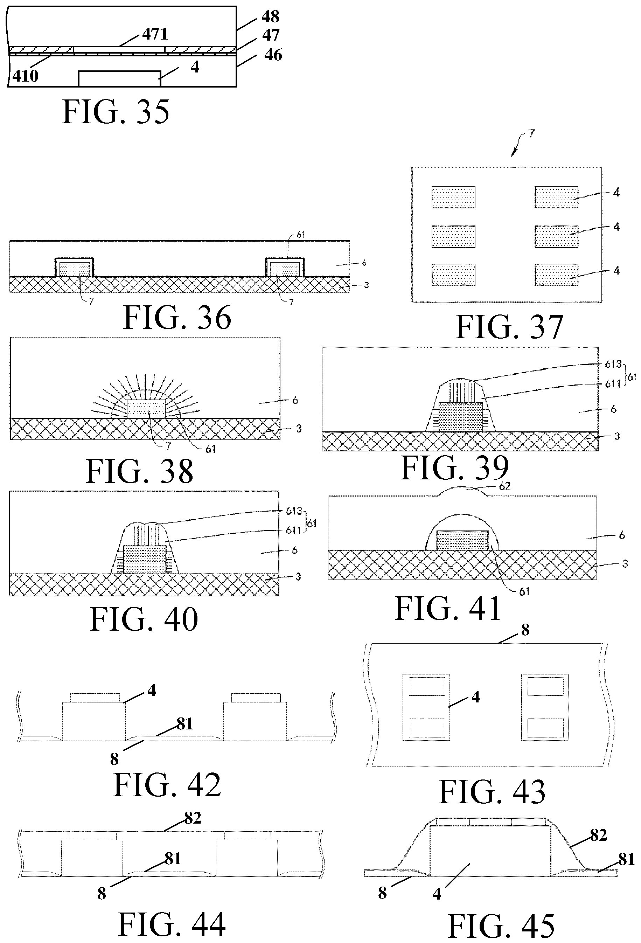

It can be understood that in the LED light source assembly of this embodiment, the through holes in the light shielding layer in the positions corresponding the light emitting devices allow the light of the light emitting devices to pass through, thereby ensuring the brightness of the LED light source assembly. Since the LED chips 4 of different sizes can be used flexibly, for example, the LED chips have different sizes, depending on the sizes of the LED chips 4 used, the LED light source assembly may have an overhigh brightness. Therefore, in some implementations, a dimming layer may also be arranged in the light emitting direction of the light emitting devices to reduce the intensity of light eventually emitted by the LED light source assembly. The arrangement of the dimming layer can simply and conveniently make the brightness of the LED light source assembly controlled within a desired range, and the thickness and light transmittance can be adjusted to control the effect of reducing light intensity of the dimming layer, thereby finally controlling the brightness of the LED light source assembly. Referring to FIG. 35, the dimming layer 410 may be arranged between the second encapsulating adhesive 46 and the light shielding layer 47. Exemplarily, the dimming layer 410 may be formed by screen printing. For example, after the arrangement of the second encapsulating adhesive 46 is completed, the dimming layer 410 is screen-printed on the surface of the second encapsulating adhesive 46. The dimming layer 410 may be a mixture of an epoxy material and melanin or other materials that can reduce light intensity. A thickness of the dimming layer 410 is selected according to the light transmittance of its material and the light intensity that needs to be reduced. For example, in an example, the thickness of the dimming layer 410 may be 5 µm. It can be understood that in the case of the same material, the dimming layer 410 with a larger thickness has a better ability to reduce light intensity. In other implementations, the dimming layer may also be arranged between the light shielding layer and the second encapsulating adhesive, or in other positions in the light emitting direction of the light emitting devices.

In some implementations, the LED light source assembly may be a combination of at least two substrates 3. The substrates 3 are spliced with each other to form a larger LED light source assembly. The LED chips 4 on the at least two substrates 3 may be driven independently, or may be driven as a whole by associating the LED chips 4 on different substrates 3. Splicing different substrates 3 will produce seams therebetween. In this example, the light shielding layer 47 may be a whole. The light shielding layer 47 may be arranged on the substrate 3 as a whole after the splicing of the substrates 3 is completed. On one substrate 3, the LED chips 4 are arranged at a certain distance from the edge of the substrate 3, and the seam is located in the non-light-transmitting region of the light shielding layer 47, i.e., in the position other than the light transmitting holes 471, which makes the seam unseen. In an example, the substrates 3 may be spliced first, the second encapsulating adhesive 46 is arranged on the substrates 3 as a whole by means including but not limited to molding, and after the second encapsulating adhesive 46 is cured, the light shielding layer 47 is formed on the second encapsulating adhesive 46. In other examples, the light shielding layer 47 may also be arranged after the substrates 3 on which the second encapsulating adhesive 46 has been provided are spliced.

### Embodiment V:

In the existing backlight module, in order to make the emitted light more uniform, the backlight source, such as LEDs, and the light guide plate are usually spaced a certain distance apart. The larger the spacing distance between the LEDs and the light guide plate, the larger the thickness of the display device, which is not conducive to realizing an ultrathin display device. The smaller the spacing distance between the LEDs and the light guide plate, the smaller the thickness of the display device, which is conductive to realizing an ultrathin display device.

Based on the above embodiments, this embodiment provides another LED light source assembly that can be used as a backlight assembly. The LED light source assembly includes the substrate described in the above embodiments, and further includes LED chips arranged in die bonding regions on the substrate. Positive and negative electrodes of the LED chips are respectively electrically connected to corresponding electrode soldering regions in the die bonding regions.

The LED light source assembly in this embodiment is used to provide a uniformly distributed light source with sufficient brightness for a liquid crystal display (LCD) panel, to make the liquid crystal display panel display images normally. The LED light source assembly can be classified into edge-lit backlight modules and direct-lit backlight modules according to distribution positions of light sources. Optical Distance (OD) refers to the distance from the LEDs of the direct-lit LED light source assembly to the light guide plate. The smaller the OD, the smaller the thickness of the LED light source assembly. The larger the OD, the larger the thickness of the backlight module.

Referring to FIG. 36, the LED light source assembly provided in this embodiment includes: a substrate 3 and a light guide plate 6. The light guide plate 6 is arranged on a side of the substrate 3, specifically on the front side of the first substrate of the substrate 3. A back side of the light guide plate 6 (i.e., a surface of the light guide plate 6 close to the substrate 3) is provided with accommodating grooves 61 corresponding to light emitting units 7, so that after the back side of the light guide plate 6 is bonded to the front side of the first substrate, the light emitting units 7 are located in the accommodating grooves 61. Thereby, according to the LED light source assembly provided in this embodiment, the light guide plate is provided with the accommodating grooves, and the light emitting units are arranged in the accommodating grooves, so that the optical distance of the backlight module is reduced even to 0, i.e., the distance from the light emitting unit to the light guide plate is zero, thereby reducing the thickness of the backlight module. Moreover, light from the light emitting units enters the light guide plate from various angles, thereby making the light emitted from the backlight module more uniform. Besides, the light emitting units are arranged in the accommodating grooves, which can enhance the dust-proofness and water-proofness of the backlight module and improve the reliability of the product.

In this embodiment, the substrate 3 is provided with a plurality of light emitting units 7. One light emitting unit 7 corresponds to one accommodating groove 61, and different light emitting units 7 correspond to different accommodating grooves 61. The plurality of light emitting units 7 are electrically connected to the substrate 3.

In some examples, the light guide plate 6 and the substrate 3 may be fixed by a binder such as an adhesive. There is no need to encapsulate the light emitting units 7 with a transparent encapsulating adhesive in advance, nor to use a support structure to fix the substrate 3, the light guide plate 6 and other components of the LED light source assembly, which simplifies the preparation process, improves the production efficiency and simplifies the structure of the LED light source assembly.

In an example, referring to FIG. 37, the light emitting unit 7 includes at least one LED chip 4. If the light emitting unit 7 includes a plurality of LEDs 4, the plurality of LED chips 4 are spaced apart in the accommodating groove 61. For example, the light emitting unit 7 may include one LED chip 4, two LED chips 4, three LED chips 4, four LED chips 4, five LED chips 4, six LED chips 4 ore more light emitting diodes.

In some examples, the light emitting unit 7 has five light-exiting surfaces, that is, light emitted by the light emitting unit 7 can exit from five surfaces. This makes the light emitted from the light emitting units 7 enter the light guide plate 6 from more angles and improves the color mixing effect of light in the light guide plate 6, thereby making the light emitted from the LED light source assembly more uniform.

In some examples, each LED chip 4 is a light emitting diode that emits light from five surfaces. The plurality of LED chips 4 in one light emitting unit 7 are arranged in an array in one accommodating groove 61. In other examples, the LED chip 4 may emit light from one surface, and through the angle design of the plurality of LED chips 4, the light emitting unit 7 may emit light from five surfaces. For example, one light emitting unit 7 has five LED chips 4 therein, and the five LED chips 4 jointly form the light emitting unit that emits light from five surfaces, so that the light emitting unit 7 in one accommodating groove 61 can emit light from five light-exiting surfaces and the emitted light can enter the light guide plate 6 from more angles, thereby improving the uniformity of the light emitted from the LED light source assembly.

In some examples, at least one light emitting unit 7 includes at least a red light LED chip, a green light LED chip and a blue light LED chip, and the mixture of light emitted by the red light LED chip, the green light LED chip and the blue light LED chip of each light emitting unit 7 forms white light. The arrangement of the red light LED chip, the green light LED chip and the blue light LED chip in one accommodating groove 61 can improve the color gamut of the backlight and the color rendering effect. The arrangement of the red light, green light, blue light and white light LED chips in one accommodating groove 61 can improve the color rendering effect and the color saturation of the display.

Referring to FIG. 36 and FIG. 38, in this example, the accommodating groove 61 may be, but not limited to, hemispherical, hemiellipsoidal, prismatic, cylindrical and truncated-pyramid-shaped. This makes light emitted by the light emitting unit 7 enter the light guide plate 6 from more angles, thereby improving the uniformity of the light emitted by the LED light source assembly. For example, in the embodiment shown in FIG. 36, the accommodating groove 61 is prismatic. In the embodiment shown in FIG. 38, the accommodating groove 61 is hemiellipsoidal.

Referring to FIG. 39 and FIG. 40, in some examples, the accommodating groove 61 includes a first slot 611 and a second slot 613 communicating with the first slot 611. The first slot 611 is arranged close to the substrate 3, and the second slot 613 is arranged away from the substrate 3. The first slot 611 is truncated-cone-shaped or cylindrical. The second slot 613 is at least one arc groove communicating with each other. Specifically, the second slot 613 may be one arc groove or a combination of two, three, four or more grooves connected with each other. By setting the second slot 613 as a multi-arc structure, the intensity of light directly above can be adjusted, and the light intensity distribution around can be changed by changing the angle of the slope of the first slot 611. This further makes light emitted by the light emitting unit 7 enter the light guide plate 6 from more angles, thereby improving the uniformity of the light emitted by the LED light source assembly. In the example of FIG. 39, the first slot 611 is truncated-cone-shaped, and the second slot 613 is arc-shaped. In the example of FIG. 40, the first slot 611 is truncated-cone-shaped, and the second slot 613 is in the shape of a plurality of arcs connected with each other.

Referring to FIG. 36, in some examples, at least one of the surface of the light guide plate 6 near to the substrate 3 and the surface of the light guide plate 6 away from the substrate 3 is provided with a rough structure. That is, at least one of the surface of the light guide plate 6 near to the substrate 3 and the surface of the light guide plate 6 away from the substrate 3 is roughened. Optionally, only the surface of the light guide plate 6 near to the substrate 3 may be roughened; or only the surface of the light guide plate 6 away from the substrate 3 is roughened; or both the surface of the light guide plate 6 near to the substrate 3 and the surface of the light guide plate 6 away from the substrate 3 may be roughened. By roughening the surface of the light guide plate 6, light entering the light guide plate 6 undergoes diffuse reflection many times, thereby making the light emitted by the LED light source assembly uniform.

Referring to FIG. 41, in some examples, the surface of the light guide plate 6 away from the substrate 3 is provided with a plurality of diffusion portions 62 arranged in an array. The diffusion portions 62 are arranged correspondingly to the accommodating grooves 61. Each accommodating groove 61 corresponds to at least one diffusion portion 62. Specifically, the diffusion portions 62 may be protrusions or depressions. By arranging the diffusion portions 62 on the surface of the light guide plate 6 away from the substrate 3, this makes a wider angle of light emitted from the surface of the light guide plate 6 away from the substrate 3, thereby making the light emitted by the LED light source assembly uniform.

In some examples, the LED light source assembly further includes a diffusion sheet. The diffusion sheet is arranged on the surface of the light guide plate 35 away from the substrate 3, and used for diffusing light, such as visible light or white light, emitted from the light guide plate 6, making the light emitted more uniform.

In some examples, the LED light source assembly further includes an intensifying sheet. The intensifying sheet is arranged on a surface of the diffusion sheet away from the light guide plate 6, and used for changing the direction of light, such as visible light or white light, emitted from the light guide plate 6, making the light, such as visible light or white light, emitted from the light guide plate 6 irradiate the display screen.

### Embodiment VI:

This embodiment provides a manufacturing method for the LED light source assembly, including:
A substrate is manufactured. In this embodiment, the substrate may be manufactured by, but not limited to, the manufacturing method for the substrate in the above embodiment. The manufactured substrate may be, but not limited to, the substrate in the above embodiment.

### An LED chip is transferred into a die bonding region on the substrate.

The LED chip in the die bonding region is electrically connected to the corresponding electrode soldering regions.

As can be seen, the manufacturing method for the LED light source assembly provided in this embodiment has the advantages of simple manufacturing process and high yield.

When transferring the LED chip onto the substrate, it is difficult for the traditional LED chip transfer process to transfer an LED chip with a size of less than 150 µm due to the diameter of the plunger. The traditional LED chip transfer method includes: expanding a chip film, ejecting the LED chip away from the chip film with an ejector pin, pulling up the LED chip with a plunger, and transferring the LED chip with a swing arm. This method has the defects of too many steps, low efficiency, high requirements for accessories, serious attrition of accessories, uneven film expansion of LED chips, low transfer yield of LED chips, hidden flaws in LED chips, etc. In the current mass transfer technique, it is required to pre-arrange chips, i.e., before the mass transfer, it is required to gradually transfer the chips in units of individual chips into a carrier panel by the above LED chip transfer method. That is, before the mass transfer, the chips are still transferred one by one, which is inefficient and still cannot avoid the above-mentioned LED chip transfer method and the defects thereof. Thus, this process is difficult to implement.

In view of the above defects, this embodiment provides a chip package structure, including a carrier tape body and a plurality of LED chips. A surface of the carrier tape body is provided with a bonding layer. Back sides of the LED chips are provided with positive and negative electrodes, and front sides of the LED chips are bonded to the carrier tape body through the bonding layer. In this embodiment, the transferring the LED chip into the die bonding region on the substrate including: aligning the LED chips bonded on the carrier tape body with the die bonding region on the substrate, the front sides of the LED chips being bonded to the carrier tape body through the bonding layer, the back sides of the LED chips being provided with the positive and negative electrodes, and the back sides of the LED chips facing the substrate;
applying pressure to the carrier tape body towards the substrate to make the carrier tape body deform until the electrodes of the LED chips contact the electrode soldering regions in the corresponding die bonding region; and
debonding the bonding layer to make the LED chips fall from the carrier tape body into the corresponding die bonding region.

In this embodiment, when the chip package structure is used for chip transfer, there is no need of manual film expansion. By changing the chip package form, the chips can be transferred efficiently in some processes. According to the chip transfer method in this embodiment, the chip package structure is placed above the substrate with the chips facing the substrate, and the chips are directly pressed onto the substrate to complete the transfer process. There is no need to pick up the chips with a transfer head and transfer the chips with the swing arm, thereby multiplying the efficiency and improving the yield. With the chip package structure, there is no need of the operations such as film expansion, replacement of films, etc., so that the chips can be transferred efficiently.

For the convenience of understanding, this embodiment will illustrate the chip package structure and the process of transferring LED chips by using the chip package structure.

This embodiment provides a chip package structure. Referring to FIG. 42, the chip package structure includes a carrier tape body 8 and LED chips 4. A material of the carrier tape body 8 may include, but not limited to, silicone, plastic and the like. In some scenarios, in order to better protect the LED chips 4, the material may be an antistatic material. A surface of the carrier tape body 8 is provided with the bonding layer 81. The bonding layer 81 functions to bond the LED chips 4. In this embodiment, the LED chips 4 are arranged onto the carrier tape body 8 through the bonding layer 81, which is more convenient and easier to implement, compared with the traditional manner of forming a groove having the size and shape matched with those of the LED chip 4 in the carrier tape body 8 to accommodate the LED chip 4. Moreover, due to the bonding of the bonding layer 81 to the LED chips 4, the LED chips 4 of the chip package structure of this embodiment does not easily come off from the carrier tape body 8, so this chip package structure is suitable for more application scenarios.

Sides of the LED chips 4 away from the electrodes are typically bases. In this example, the bases of the LED chips 4 are bonded to the carrier tape body 8. As an example, referring to FIG. 43, when the LED chips 4 are arranged on the carrier tape body 8, the two electrodes of each LED chip 4 are placed along a width direction of the carrier tape body 8. Of course, in practical applications, the direction along which the chips are placed on the carrier tape body may be changed according to demands.

On the carrier tape body of this embodiment, a plurality of chips are arranged at preset intervals. It can be understood that the chip package structure of this embodiment store the chips. In some scenarios, the chip package structure may also be used to provide the chips and transfer the chips to the substrate.

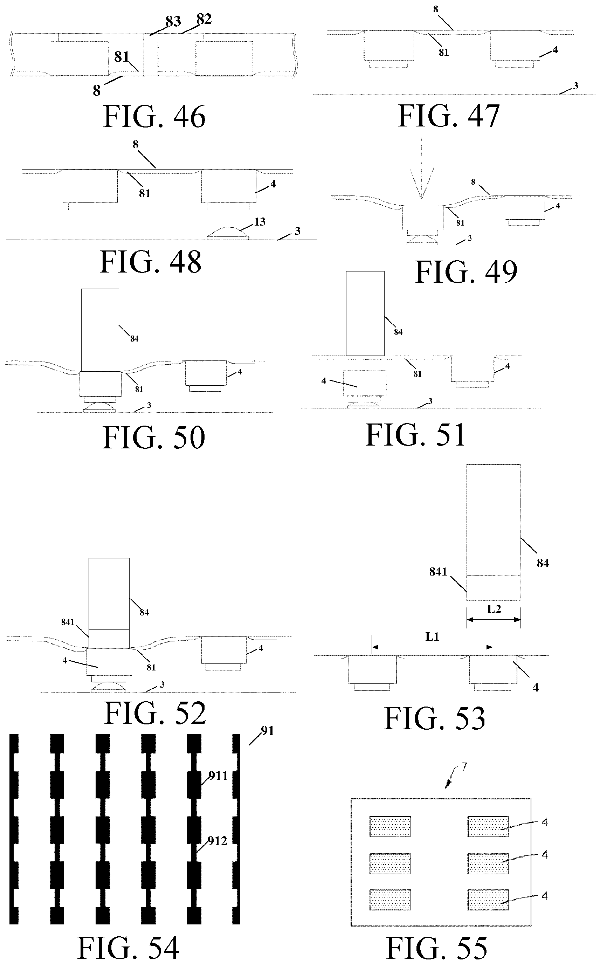

In some implementations, referring to FIG. 44, in order to protect the LED chips 4 on the carrier tape body 8 and provide a better storage effect, a surface of the chip package structure provided with the LED chips 4 further includes a protective film 82. The protective film 82 covers at least the LED chips 4 on the chip package structure. The protective film may be an electrostatic film that covers the chips by electrostatic adsorption. Of course, in order to avoid possible effects of static electricity on the chip under some conditions, the protective film may be arranged by utilizing the bonding layer. Referring to FIG. 45, the protective film 82 may contact the bonding layer 81 at the interval between the LED chips 4, and be stably arranged on the chip package structure through the bonding layer 81 to protect the LED chips 4. FIG. 46 shows another chip package structure in which a partition 83 is arranged between the LED chips 4. The partition 83 may be integrally formed with the carrier tape body 8. An end surface of the partition 83 is coated with a bonding material. The protective film 82 contacts the partition 83, and covers the LED chips 4 through the bonding material on the end surface of the partition 83.

In some implementations, the carrier tape body may also be provided with conveying holes for conveying purposes, and the movement of the chip package structure may be realized through the conveying holes. Besides, in some specific implementation processes, the conveying holes may be arranged beside each chip, and the interval between the two conveying holes is consistent with that between the chips. The positions of the chips are accurately controlled by controlling the positions of the conveying holes. Of course, the conveying may also be realized through the rotation of rollers rather than the conveying holes.

This embodiment further provides a chip transfer method, which may be used to transfer chips by using the above chip package structure. Referring to FIG. 47 to FIG. 53, the chip transfer method includes:
The substrate is arranged below the chip package structure, with a side of the chip package structure provided with the chips facing the substrate.

It should be noted that the chip package structure is the chip package structure described above in this embodiment. As shown in FIG. 47, the substrate 3 may be placed horizontally. In practical applications, the substrate may be placed on an operating table, and the chip package structure is arranged above the substrate 3 with the LED chips 4 facing down. It should be noted that the up and down direction referred to in this embodiment, i.e., the direction shown in the figures, is the direction of gravity.

The chip to be transferred is aligned with the die bonding region on the substrate. The chips to be transferred may be aligned with the die bonding region by moving the chip package structure and/or moving the substrate, i.e., the chips to be transferred and the die bonding region may be on the same vertical line.

For example, referring to FIG. 48, the two electrodes of the LED chip 4 are respectively aligned with the electrode soldering regions 13 on the substrate. It can be understood that a solder may be pre-arranged on the electrode soldering regions 13 of the substrate 3, so that soldering and other subsequent production steps can be performed after the LED chips 4 are transferred to the substrate 36. The chips may be soldered at one time after all the chips are placed on the substrate 3, or in batches.

Pressure is applied to the carrier tape body towards the substrate 3 to make the carrier tape body 8 deform until the LED chips to be transferred contacts the substrate 3.

It can be understood that the carrier tape body used by the chip package structure in this embodiment has certain flexibility, and thus can be deformed to some extent without breaking. As shown in FIG. 49, a downward external force is applied to the region of the carrier tape body 8 provided with the LED chips 4, so that the carrier tape body 8 is deformed and drives the LED chip 4 to be transferred towards the substrate 3. As can be seen, in the chip transfer method of this embodiment, the distance between the substrate and the chips should not be set too far, but should be within the controllable deformation range of the carrier tape body, so that the chips can make contact with the substrate. In practical applications, the appropriate set distance between the substrate and the chips can be tested through actual tests.

As shown in FIG. 50, in some implementations, this force may be applied through a push rod 84. The push rod 84 is arranged above the chip package structure. The push rod 84 may be controlled to move up and down, or in the horizontal direction to make position adjustment, so as to realize better alignment or adapt to more transfer scenarios. The push rod 84 is located above the chips to be transferred, the push rod may be fixed in the horizontal direction, and the chip package structure and the substrate are moved to the corresponding position below the push rod 84 or the push rod 84 may be moved to make position adjustment itself. As shown in FIG. 50, the push rod 84 is controlled to move down such that the push rod 84 contacts the surface of the carrier tape body 8 without the LED chips 4, the push rod 84 presses down the carrier tape body 8 to make the carrier tape body deform toward the substrate 3, and at the same time, the LED chip 4 to be transferred is also driven to move toward the substrate 3 until it contacts the substrate 3.

The push rod may have multiple shapes, and the bottom of the push rod may be, but not limited to, flat, round-headed and sharp. The bottom of the push rod referred to in this embodiment is the side of the push rod in contact with the chip package structure. It can be understood that in this embodiment, the chip pushed by the push rod can be transferred onto the substrate. When the push rod pushes only one chip, one chip can be transferred to the substrate at one time. When the push rod can cover more chips, for example, when the bottom of the push rod is flat and has a large area or a plurality of push rods are provided, at least two chips can be pressed down at the same time to contact the substrate so as to be transferred. In the implementation in which the push rod drives at least two chips to be transferred at the same time, the chips may be pre-arranged on the carrier tape body, so that these chips can be aligned with the corresponding die bonding regions at the same time.

In practical applications, the distance between the substrate and the chips is usually set constant, so a movement distance of the push rod may be preset. When the push rod moves down the preset distance, the chip contacts the substrate. The contact referred to here may also include contact between the chip and the soldering material on the substrate. Alternatively, it can be set that when the substrate is subjected to a certain pressure, the movement of the push rod is stopped. Alternatively, other methods that can determine that the chip to be transferred has contacted the substrate may be used to control the time when the push rod stops moving. The LED chips 4 are made to come off from the carrier tape body 8, so that the LED chip 4 to be transferred is transferred to the substrate 3.

When the LED chips 4 come off from the carrier tape body 8, the LED chips 4 stay on the substrate 3 due to gravity, so that the chips are transferred to the substrate. It can be understood that according to the chip transfer method in this embodiment, before the chips come off from the carrier tape body, the chips have been aligned with the corresponding region on the substrate, and when the chips contact the substrate, the chips are already in the target position of this transfer. Therefore, after the chips come off from the carrier tape body, there is no need to pick up the chips with the plunger or transfer the chips with the swing arm, and the chips directly stay in the desired position basically without flipping, standing or misplacement. As can be seen, compared with the traditional chip transfer method, the chip transfer method of this embodiment has multiplied efficiency and higher yield. As shown in FIG. 51, after the push rod 84 rises, the LED chip 4 stays on the substrate 3 due to the gravity.

In some embodiments, the chip package structure further includes the protective film, so before the chip is pressed down to the substrate, a step of removing the protective film is further included. In an example, "the chip is pressed down with the ejector pin or the push rod with a sharp bottom to make the chip come off from the chip package structure" may be "when the ejector pin or the push rod applies a certain pressure to the carrier tape body, the carrier tape body is punctured such that the chip is pushed off from the carrier tape body". In this embodiment, the side of the chip provided with the electrodes faces the substrate 3, so after the carrier tape body is punctured by the ejector pin or the push rod, the ejector pin or the push rod only contacts the side of the chip with the base. The side with the base usually has better hardness than the side with the electrodes. Thus, compared with the traditional chip transfer method, the chip transfer method of this embodiment can reduce the possible damage to the chip caused by ejecting the chip.

In some embodiments, the bonding layer 81 of the chip package structure includes a photolytic adhesive or pyrolytic adhesive, and the bottom of the push rod can heat up and/or emit light. In this implementation, the chips can be made to come off from the chip package structure by debonding the bonding layer without damaging the carrier tape body. As an example, referring to FIG. 52, the bottom of the push rod 84 includes a push rod head 841. The push rod head 841 may be flat and can heat up. When the push rod head 841 presses down the chip package structure, it does not puncture the carrier tape body 8. Instead, after the push rod 84 presses down the LED chip 4 to the substrate 3, the push rod head 841 is controlled to heat up. The pyrolytic adhesive that bonds the LED chip 4 to be transferred is debonded by the heat, such that the chip comes off from the carrier tape body. The push rod may be controlled to rise. Due to the rise of the push rod, the deformation of the carrier band is reduced. Due to the action of gravity, the chip stays on the substrate. Similarly, if the bonding layer includes the photolytic adhesive, then the push rod may have a push rod head that can emit light capable of debonding the photolytic adhesive. In some specific implementation processes, the push rod head of the push rod may be changed or a push rod head that can emit both light and heat may be adopted, to adapt to the chip package structure using different types of bonding layers.

In some embodiments, the chips on the chip package structure are arranged along a length direction, and may be arranged in one row or multiple rows. In order to realize more accurate transfer, a large interval may be set between the chips, so that only chips in one column are pressed down to the substrate in one press-down process of the push rod. It should be noted that in this embodiment, the chips in one row are a series of chips in the length direction of the chip package structure, and the chips in one column are a series of chips in the width direction of the chip package structure. In the traditional chip transfer process, due the small size of the chip, the size of the ejector pin also needs to be very small, which proposes a high requirement for the ejector pin and leads to serious attrition and high proneness to misplacement. Moreover, when the plunger or other device is used to pick up the chip, the requirements for the size and precision of the pick-up device such as the plunger are also extremely high, and the use of an unsatisfactory pick-up device may lead to pick-ups in inappropriate positions, missed pick-ups and failed pick-ups. In this embodiment, for example, referring to FIG. 53, an interval L1 between one LED chip 4 and the other LED chip 4 in the length direction of the chip package structure may be set to be greater than a width L2 of the push rod in the length direction of the carrier band. If the LED chips 4 are arranged in one row, the push rod 84 presses down only one LED chip 4 to the substrate, so that the accurate transfer of individual chips to be transferred can be realized precisely. This chip package structure can be used to transfer extremely small chips such as mini-LED chips, micro-LED chips and nano-LED chips, and has the advantages of low requirements for precision and size of the push rod and other accessories, low attrition and less proneness to failed transfer. The problem that the accessories are limited by the chip size in the chip transfer process is solved to some extent. It can be understood that in the case that there are multiple rows of chips on the chip package structure, further setting an interval L3 between the chips in the width direction of the chip package structure to be greater than a width L4 of the push rod in the length direction of the carrier band can also realize accurate transfer of individual chips to be transferred under the conditions of low requirements for precision and size of the push rod and other accessories and low attrition.

After the current chips to be transferred are transferred to the substrate, the chip package structure is moved such that the next batch of chips to be transferred on the chip package structure are aligned with the die bonding regions on the substrate, and the next batch of chips to be transferred are transferred to the substrate. The transfer process is the same as the transfer process described above, i.e., the chips that need to be transferred are pressed down to the substrate and the chips are made to come off from the chip package structure, which will not be repeated here. The above steps are repeated until all the chips that need to be transferred are transferred. During the transfer process, a conveyor may be used to convey the chip package structure. For example, in some examples, rollers and other tape winding devices may also be used to drive the chip package structure to move, and at the same time, wind up the carrier tape body after the chip transfer for recycling purposes. The undamaged carrier tape body can be reused to package chips to form the chip package structure.

In some examples of this embodiment, the LED light source assembly may further include, but not limited to, the capsule described in the above embodiment. In this case, after the LED chips in the die bonding region are electrically connected to the corresponding electrode soldering regions, a step of forming a capsule on the first substrate of the substrate may further be included. For the convenience of understanding, this embodiment will describe several capsule manufacturing methods below as examples.

A process for manufacturing the capsule of Example II in Embodiment IV includes, but not limited to:
S601: Forming an encapsulating adhesive covering the die bonding region and the LED chips in the die bonding region on the front side of the first substrate.

For example, the encapsulating adhesive covering the LED chips in each die bonding region may be formed on the front side of the first substrate by, for example, but not limited to, dispensing, molding, etc. The encapsulating adhesive may be, but not limited to, a luminescent conversion layer.

S602: Removing the encapsulating adhesive around each die bonding region respectively by cutting to obtain a reflective adhesive layer groove. The encapsulating adhesive in one die bonding region after cutting constitutes one encapsulating adhesive unit.

S603: Forming a first reflective adhesive layer respectively enclosing the encapsulating adhesive unit in each die bonding region in the reflective adhesive layer groove.

The first reflective adhesive layer respectively enclosing the encapsulating adhesive unit in each die bonding region may be formed in each reflective adhesive layer groove by, for example, but not limited to, dispensing, molding, etc. The enclosing may be performed in units of individual or multiple LED chips in each die bonding region, or in units of individual die bonding regions or multiple die bonding regions according to demands, or all the die bonding regions on the front side are directly enclosed as a whole and only one enclosure is formed on the periphery of the front side.

For the convenience of understanding, this embodiment will describe, by taking the LED chips being flip LED chips (for normal LED chips or vertical LED chips, the manufacturing process is similar to that of the flip LED chips) as an example, a process for manufacturing an LED light source assembly by encapsulating the flip LED chips based on the substrate manufactured above, which includes, but not limited to:
S701: Putting the manufactured substrate into a bin, and preheat the bin at 120°C to 170°C for 1 h to 4 h.
S702: Dispensing a flux at corresponding die bonding positions on the front side of the substrate, and place the flip LED chips.
S703: Placing the substrate on which the flip LED chips have been placed on a carrier, and passing the carrier through a vacuum soldering system (12-temperature zone system, with nitrogen introduced).
S704: Performing plasma cleaning.
S705: Preparing a fluorescent adhesive. In this example, the fluorescent adhesive may be prepared by uniformly stirring an encapsulating adhesive component A, an encapsulating adhesive component B, red phosphor and green phosphor according to a certain weight ratio.
S706: Setting a mold temperature of a molding press to 140°C to 160°C, adding the fluorescent adhesive prepared in advance into a barrel, injecting the liquid adhesive, closing the mold, and heating the mold for 120 s to 240 s; and taking out the substrate, and baking the substrate at 140°C to 170°C for 1.5 h to 3.5 h.
S707: Preparing a transparent adhesive. The transparent adhesive is prepared by uniformly stirring an encapsulating adhesive component A and an encapsulating adhesive component B according to a certain weight ratio.
S708: Setting the mold temperature of the molding press to 140°C to 160°C, adding the transparent adhesive prepared in advance into a barrel, injecting the liquid adhesive, closing the mold, and heating the mold for 120 s to 240 s; and taking out the substrate, and baking the substrate at 140°C to 160°C for 1.5 h to 3.5 h.
S709: Making kerfs in the adhesive without cutting the substrate.
S710: Preparing a white wall adhesive. The white wall adhesive is prepared by uniformly stirring a white wall adhesive component A and a white wall adhesive component B according to a certain weight ratio.
S711: Filling the kerfs with the white wall adhesive by dispensing or molding, and baking the substrate at 140°C to 160°C for 3.5 h to 6.5 h.
S712: Thinning the adhesive layer on the top by polishing to expose the regular transparent adhesive surface and the white wall surface. This manufacturing process is simple and efficient, and low in cost and high in yield.
S713: Optionally, dicing the LED light source assembly into individual finished LED light beads or individual LED light bead bars according to demands, and drying the finished product at 140°C to 160°C.

An exemplary process for manufacturing the capsule of Example III in Embodiment IV includes, but not limited to:
S801: Arranging the LED chip on the substrate, and connecting the electrodes of the LED chip to the electrode soldering regions in the die bonding region on the substrate.
S802: Forming a lens cap covering the LED chip by using a lens adhesive.

In this example, the lens adhesive used may be a transparent adhesive, so that the lens cap can be formed after the transparent adhesive is cured. In an example, the lens cap may be formed on the LED chip of the substrate directly by dispensing. In this case, the surface of the lens cap is a smooth curved surface. In other examples, the lens cap may be formed by precise pressing. For example, the lens cap whose longitudinal section is in the shape of a rectangle, a trapezoid or other shapes is formed by the precise pressing.

It can be understood that in other examples, during the manufacturing process of the LED light source assembly, the lens cap may also be formed separately in advance and then arranged onto the LED chip, rather than forming the lens cap on the LED chip by using the uncured lens adhesive.

S803: Forming a white adhesive wall, i.e., a second reflective adhesive layer, in the gap between adjacent lens caps by using a white adhesive.

After the lens caps 73 are formed, i.e., after the lens adhesive is cured, the white adhesive wall may be formed in the gaps between adjacent lens caps by using the white adhesive. In this embodiment, the white adhesive wall is attached to the substrate, which means that the lowest point of the white adhesive wall is at the surface of the substrate.

In some examples of this embodiment, the white adhesive may be pressed in the whole region where there are no lens caps on the substrate after all the lens caps have been arranged on the substrate, so that after the white adhesive is cured, the white adhesive wall can be formed. Of course, this embodiment does not exclude the implementation of forming the white adhesive wall respectively in the gaps. Nevertheless, the implementation of forming the white adhesive wall by pressing the white adhesive in the whole region where there are no lens caps is more efficient than the implementation of forming the white adhesive wall respectively.

In this embodiment, the white adhesive may be formed by, but not limited to, mixing silicone with at least one of boron trioxide and ceramics.

An exemplary process for manufacturing the capsule of Example IV in Embodiment IV includes, but not limited to:
S901: Preparing a mixed adhesive solution for a third reflective adhesive layer, a mixed adhesive solution for a fourth reflective adhesive layer, and a mixed adhesive solution for a diffusion layer according to a desired ratio.
S902: Arranging the third reflective layer on the front side of the first substrate and/or the front light-exiting surface of the LED chip by spraying, screen printing, 3D printing, etc.
S903: Arranging the diffusion layer on the third reflective layer through steel mesh coating, mold pressing, etc.
S904: Finally, arranging the fourth reflective layer on the diffusion layer through, but not limited to, spraying, screen printing, 3D printing, etc.

An exemplary process for manufacturing the capsule of Example V in Embodiment IV includes, but not limited to:
After the LED chips in the die bonding region are electrically connected to the corresponding electrode soldering regions, a second encapsulating adhesive layer covering the die bonding region and the LED chips in the die bonding region is formed on the front side of the first substrate.

A black target is placed on a platform with a magnetic field, and the substrate is placed opposite to the black target. The second encapsulating adhesive layer is opposite to the black target.

A first region on the second encapsulating adhesive layer corresponding to each of the LED chips is covered with masks, and the black target is deposited onto a surface of the second encapsulating adhesive layer through magnetron sputtering to form a black target molecule layer. The black target molecule layer constitutes a black matrix.

In this embodiment, the magnetron sputtering process is performed in vacuum. The platform with the magnetic field and the substrate placed thereon are both in the vacuum environment. The vacuum environment is filled with an inert gas (e.g., argon or other inert gases), and glow discharge of low-pressure inert gas may be used to produce incident ions. An electric field is applied to the vacuum environment until the inert gas is broken down and ionized into electrons. The electrons constantly impact gas molecules under the action of the magnetic field of the platform where the black target is placed such that more electrons are released. At the same time, positive ions are impacted and bombard the black target, such that black target molecules are ejected onto the substrate and deposit a black target molecule layer on the substrate. In this embodiment, the first regions on the substrate corresponding to the LED chips are covered by the masks such that the black matrix is formed on the substrate. There are no black target molecules deposited in the first regions corresponding to the LED chips, so that light of the LED chips can pass through. The above implementation is only an example of magnetron sputtering, and other methods may also be used to realize magnetron sputtering.

The covering the first region on the second encapsulating adhesive layer corresponding to each of the LED chips with the masks, and depositing the black target onto the surface of the second encapsulating adhesive layer through magnetron sputtering to form the black target molecule layer may be implemented by any one of the following two methods:
Method I: Magnetron sputtering is performed on the substrate at least once respectively by using at least two different masks. After the magnetron sputtering using the masks is completed, the region on the substrate other than the first region is deposited with the black target. It can be understood that in this embodiment, all the masks cover the first regions, and no black target is deposited in the first regions during any magnetron sputtering process.

A material of the masks may be any non-deformable material, and these masks can be reused. In some specific implementation processes, the masks may be processed by laser, and the material of the masks may be a material easily processed by laser. In this embodiment, the mask may be made of a steel sheet and formed through laser processing.

Since the magnetron sputtering is performed once for each of the masks, in order to reduce the number of times of magnetron sputtering so as to improve the production efficiency and control the cost, the total number of the masks can be minimized. In some implementations, the covering the region on the substrate corresponding to the LED chip with the masks, and depositing the black target onto the surface of the substrate by magnetron sputtering to form the black matrix (i.e., light shielding layer) includes:
S1001: Arranging a first mask on the second encapsulating adhesive layer. The first mask covers the first regions and the second region on the second encapsulating adhesive layer. The first regions are regions on the second encapsulating adhesive layer corresponding to each LED chip, and the second regions are regions between the adjacent LED chips in each column of LED chips. The remaining region on the second encapsulating adhesive layer is a third region. For example, as shown in FIG. 54, in the first mask (the frame of the first mask 91 is not shown), the black regions are the regions covered by the first mask, and the white regions are hollowed regions. The regions on the first mask 91 corresponding to the first regions are shown as 911 in the figure, and the regions corresponding to the second regions are shown as 912 in the figure. The remaining regions of the first mask 91 are hollowed out, so that the black target molecules can pass through.
S1002: Performing sputtering on the second encapsulating adhesive layer to make the black target deposit onto a region on the second encapsulating adhesive layer other than the first regions and the second regions.
S1003: Removing the first mask, and arranging a second mask on the second encapsulating adhesive layer. The second mask covers the first regions and the third regions on the second encapsulating adhesive layer. The third regions do not overlap with the second regions. For example, referring to FIG. 55, corresponding to the first mask 91 shown in FIG. 54, the second mask 92 is hollowed out only in the locations corresponding to each second region. The first mask 91 and the second mask 92 are used alternately, such that all the regions on the substrate other than the first regions are deposited with the black target molecules, forming the black matrix.
S1004: Performing sputtering on the second encapsulating adhesive layer again to make the black target deposit onto the regions on the second encapsulating adhesive layer other than the first regions and the third regions.

The two examples above are only two optional arrangement methods for the masks. In practical applications, any form of the masks may be selected or a larger number of masks may be used, as long as the black matrix can be formed, which will not be described in detail.

Method II: A mask layer is formed directly in each first region on the second encapsulating adhesive layer, and no mask layer is arranged in the other regions. An exemplary process includes:
S 1101: Covering the second encapsulating adhesive layer with a mask material.

In this example, the mask material may be a negative photolithography material. Exemplarily, the negative photolithography material includes, but not limited to, a negative photoresist or other negative photolithography materials that can be processed by photolithography.

S 1102: Removing the mask material on the second encapsulating adhesive layer the regions other than the first regions to form the mask layer.

For example, a third mask is arranged on the negative photolithography material. The third mask only exposes the negative photolithography material in the first regions, and completely covers the remaining regions. The negative photolithography material is patterned, including: irradiating the negative photolithography material with specific light (exposure), and removing the negative photolithography material that is not irradiated with the specific light using a developer (development). Since the third mask only exposes the negative photolithography material in the first regions, after the exposure and the development, only the negative photolithography material in the first regions remains, forming the mask layer.

S 1103 : Performing magnetron sputtering on the second encapsulating adhesive layer formed with the mask layer to make the black target deposit onto the regions on the second encapsulating adhesive layer other than the first regions.

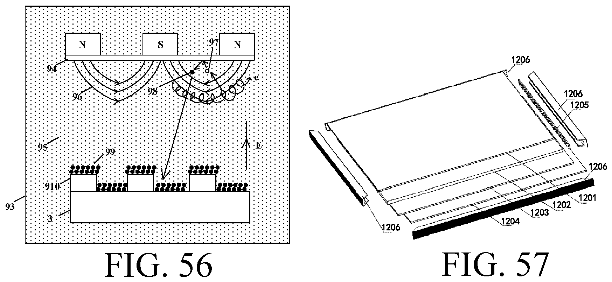

For example, as shown in FIG. 56, in a vacuum vessel 93, the substrate 3 is arranged to be opposite to the black target 94, and the vacuum vessel 93 is filled with an inert gas 95. After an electric field E is applied, electrons e constantly impact gas molecules under the action of a magnetic field 96 of the platform where the black target 94 is placed such that more electrons e are released. At the same time, positive ions 97 are impacted and bombard the black target 94, such that black target molecules 98 are sputtered onto the substrate 3 and deposit a black molecule layer 99 on the surface of the substrate 3. The black molecule layer 99 is deposited on the region of the substrate 3 that is not covered by the black molecule layer 99, and the mask layer formed by the negative photolithography material 910 blocks the black target molecules sputtered toward the first region. After the black matrix is formed, the negative photolithography material of the mask layer may be removed by debonding by ways of, but not limited to, plasma wind, heating and irradiation with target light.

In this embodiment, after the LED light source assembly in the above example is manufactured, the obtained complete-board light source may be used as a direct display panel, or diced according to demands to obtain small-unit LED light sources, which may be, for example, but not limited to, LED light beads, LED light bars (which may also be used as the backlight of an LCD screen), LED matrix units, etc. During the cutting, at least one of the first substrate and the second substrate may be formed with a cutting mark for indicating a cutting position. For example, the cutting mark in an example is shown as the reference sign 16 in FIG. 1. In this embodiment, after the LED chips in the die bonding region are electrically connected to the corresponding electrode soldering regions, or after the above capsule is formed, the following step may also be included:
Cutting is performed according to the dicing position indicated by the cutting mark, second through holes are cut into two parts and second metal conductive layers on side walls of the second through holes constitute a part of external soldering regions. The cutting may be performed in units of rows or columns, or in units of individual die bonding regions, which depends on the specific application demands.

As can be seen, the manufacturing process of the substrate provided in this embodiment is simple and efficient, and low in cost. As can be seen, the manufacturing process of the substrate provided in this embodiment is simple and efficient, and low in cost. The LED light source assembly manufactured with the substrate can be widely and better applied to the field of LCD backlighting of electronic products such as mobile phones, notebook computers and tablet computers, and the field of LCD backlighting of industrial control, wearable and eye protection products. Moreover, according to the manufacturing process, the mature technique is used to make the through holes in the single-layer substrate, and another single-layer substrate is bonded thereon to make second through holes (i.e., second through holes) structure similar to a single-layer substrate, thereby greatly lowering the requirements for high-precision equipment. In this way, by optimizing and improving the existing precision equipment and the existing mature technique, the PCB substrate with the second through hole structures can be mass-produced. Thus, the manufacturing process can avoid the difficulty in precision control of drilling depth of the PCB substrate with the second through hole structures made of single-layer-substrate PCB, and realize industrial production. Moreover, the manufacturing process can greatly lower the threshold of the encapsulation technique. Any company having liquid adhesive molding equipment and technique is capable of industrial production of the manufacturing process.

According to the LED light source assembly, the interval between chips can be reduced, so that the color mixing distance is reduced, thereby reducing the bezel. Thus, in the case of the same screen size, the screen-to-body ratio is improved, which improves the user experience of the bezelless display and is beneficial to improve the market competitiveness of the product.

It should be understood that the display screen in this embodiment can be applied to, but not limited to, various smart mobile terminals, in-vehicle terminals, PCs, displays, electronic advertising boards and the like. For example, this embodiment further provides a display panel, including the LED light source assembly in the above example as a backlight source. As shown in FIG. 57, the display panel includes an outer frame 1206, a film 1201 assembled in the outer frame 1206, a light guide plate 1202, a reflector 1203, a metal back plate 1204, and a backlight source 1205 arranged corresponding to the film 1201, the light guide plate 1202, the reflector 1203 and the metal back plate 1204. The backlight source 1205 emits light on an upper side of the display back plate. It should be understood that FIG. 57 only shows an example of the display panel, and the specific structure of the display panel can be set flexibly and will not be described in detail. The display panel has the advantages of better heat dissipation performance, more LED chips arranged in the same area, narrower bezel, etc.

It should be understood that the applications of the present application are not limited to the above examples. Those skilled in the art can make improvements or changes according to the above description, and all these improvements and changes shall fall into the scope of the appended claims of the present application.

## Claims

1. A substrate (3), used for manufacturing an LED light source assembly, **characterized in that** the substrate (3) comprises a first substrate (1) and a second substrate (2) arranged in a stacked manner;
a front side of the first substrate (1) is provided with a die bonding region (G1/G2) and at least two electrode soldering regions (13) located in the die bonding region (G1/G2) and configured to be respectively connected to positive and negative electrodes of an LED chip (4); a back side of the first substrate (1) is provided with at least two first conductive regions (14) respectively corresponding to the electrode soldering regions (13); the substrate (3) further comprises first conductive members (12) embedded in the first substrate (1) and electrically connecting the electrode soldering regions (13) to the corresponding first conductive regions (14); and
a front side of the second substrate (2) is provided with at least two second conductive regions (22) respectively corresponding to the first conductive regions (14), and the first conductive regions (14) and the corresponding second conductive regions (22) are electrically connected; a back side of the second substrate (2) is provided with at least two third conductive regions (23) respectively corresponding to the second conductive regions (22); and the substrate (3) further comprises second conductive members (24) embedded in the second substrate (2) and electrically connecting the second conductive regions (22) to the corresponding third conductive regions (23).

2. The substrate (3) according to claim 1, **characterized in that** the first conductive members (12) are first metal conductive layers formed on side walls of first through holes (11) or metal conductive pillars filled in the first through holes (11); wherein the second conductive members (24) are second metal conductive layers formed on side walls of second through holes (21), and the first through holes (11) and the second through holes (21) do not overlap; the die bonding region (G1/G2) is configured to hold a plurality of LED chips (4); at least one of the electrode soldering regions (13) in the die bonding region (G1/G2) is used as a common electrode for electrically connecting electrodes of at least two of the corresponding LEDs, and/or at least one of the first conductive regions (14) is used as a common electrode for electrically connecting the at least two corresponding electrode soldering regions (13), and/or at least one of the second conductive regions (22) is used as a common electrode for electrically connecting the at least two corresponding first conductive regions (14); the electrode soldering region (13) comprises a copper coating formed on the first substrate (1), a nickel coating formed on the copper coating, and a gold coating formed on the nickel coating, and/or the third conductive region (23) comprises a copper coating formed on the second substrate (2), a nickel coating formed on the copper coating, and a gold coating formed on the nickel coating; at least one pair of the first conductive region (14) and the corresponding second conductive region (22) at least partially overlap, and/or at least one pair of the first conductive region (14) and the corresponding second conductive region (22) do not overlap; the substrate (3) further comprises a conductive adhesive layer filled between the first conductive regions (14) and the second conductive regions (22) to electrically connect the first conductive regions (14) to the second conductive regions (22); the first substrate (1) is provided with at least three first alignment holes (15), at least three of the first alignment holes (15) are not on a same straight line, the second substrate (2) is provided with at least three second alignment holes (25) or at least three alignment protrusions corresponding to the first alignment holes (15), and the first substrate (1) and the second substrate (2), when being arranged in the stacked manner, are aligned through the first alignment hole (15) and the corresponding second alignment hole (25) or through the first alignment hole (15) and the corresponding alignment protrusion; and the substrate (3) further comprises at least one of a first bonding layer (25) arranged on the back side of the first substrate (1) and in a region other than the first conductive regions (14) and a second bonding layer (25) arranged on the front side of the second substrate (2) and in a region other than the second conductive regions (22), and the first substrate (1) and the second substrate (2), when being arranged in the stacked manner, are bonded and fixed through at least one of the first bonding layer (25) and the second bonding layer (25).

3. The substrate (3) according to claim 1, **characterized in that** the substrate (3) further comprises a solder resist ink layer (33) and a plurality of first locating structures (313) arranged on the front side of the first substrate (1) and located around the electrode soldering regions (311), and the at least two electrode soldering regions (311) extend on the front side of the first substrate (1) along a first direction (X) and are spaced apart;
the solder resist ink layer (33) is arranged on the front side of the first substrate (1), and comprises a windowed region (331) for exposing the electrode soldering regions (311), a plurality of hollowed regions (332) for exposing the plurality of first locating structures (313) and a plurality of second locating structures (333) located around the windowed region (331) and spaced apart from the plurality of first locating structures (313); and
a coordinate of the die bonding region (312) in the first direction (X) is determined according to the plurality of second locating structures (333), a coordinate of the die bonding region (312) in a second direction (Y) is determined according to the plurality of first locating structures (313), and the second direction (Y) is perpendicular to the first direction (X) such that the die bonding region (312) is located in the windowed region (331) and covers the electrode soldering regions (311).

4. The substrate (3) according to claim 3, **characterized in that** a pattern formed by connecting lines formed by sequentially connecting the plurality of first locating structures (313) is a non-regular polygon, and a maximum distance between the plurality of first locating structures (313) along the first direction (X) is not equal to a maximum distance along the second direction (Y).

5. A manufacturing method for the substrate (3) according to claim 1, **characterized in that** the manufacturing method for the substrate (3) comprises:
forming at least two electrode soldering regions (13) and at least two corresponding first conductive regions (14) respectively on a front side and a back side of a first substrate (1) by a gold plating process, and forming at least two corresponding second conductive regions (22) and at least two corresponding third conductive regions (23) respectively on a front side and a back side of a second substrate (2) by the gold plating process; providing first through holes (11) communicating the electrode soldering regions (13) with the corresponding first conductive regions (14) and second through holes (21) communicating the second conductive regions (22) with the corresponding third conductive regions (23) respectively in the first substrate (1) and the second substrate (2), and forming first conductive members (12) and second conductive members (24) respectively in the first through holes (11) and the second through holes (21); and
aligning and bonding the back side of the first substrate (1) to the front side of the second substrate (2), and electrically connecting the first conductive regions (14) to the corresponding second conductive regions (22).

6. The manufacturing method for the substrate (3) according to claim 5, **characterized in that** before the alinigng and bonding the back side of the first substrate (1) to the front side of the second substrate (2), the method further comprises at least one of:
arranging a conductive adhesive layer between the first conductive regions (14) and the corresponding second conductive regions (22);
arranging a first bonding layer (25) on the back side of the first substrate (1) and in a region other than the first conductive regions (14); and
arranging a second bonding layer (25) on the front side of the second substrate (2) and in a region other than the second conductive regions (22).

7. An LED light source assembly, **characterized in that** the LED light source assembly comprises the substrate (3) according to claim 1 and further comprising an LED chips (4) arranged in the die bonding region, positive and negative electrodes of the LED chips (4) being respectively electrically connected to corresponding electrode soldering regions in the die bonding region.

8. The LED light source assembly according to claim 7, **characterized in that** the LED light source assembly further comprises a capsule, the capsule comprising any one of:
a first encapsulating adhesive layer (51) arranged on a front side of a first substrate (1) and covering the LED chip (4);
an encapsulating adhesive unit (51) arranged on the front side of the first substrate (1) and covering the die bonding region and the LED chip (4) in the die bonding region, and a first reflective adhesive layer (53) arranged on the front side of the first substrate (1) and enclosing the encapsulating adhesive unit (51);
a lens cap (41) arranged on the front side of the first substrate (1) and covering the LED chip (4), and a second reflective adhesive layer (42) arranged on the front side of the first substrate (1) and enclosing the lens cap (41); the second reflective adhesive layer (42) at least partially covering the lens cap (41), and a height of the highest point of the second reflective adhesive layer (42) being less than or equal to a height of the highest point of the lens cap (41), and/or the height of the highest point of the second reflective adhesive layer (42) being greater than or equal to a thickness of the LED chip (4);
a third reflective adhesive layer arranged on the front side of the first substrate (1) and covering at least front light-exiting surfaces of the LED chips (4), a diffusion layer (44) arranged on the third reflective adhesive layer and a fourth reflective adhesive layer arranged on the diffusion layer (44), the front light-exiting surfaces of the LED chips (4) being surfaces of the LED chips (4) away from the first substrate (1); the diffusion layer (44) comprising a front diffusion region located directly above the front light-exiting surfaces and a side diffusion region located between adjacent LED chips (4); and/or the fourth reflective adhesive layer comprising a first reflective region located directly above the front light-exiting surfaces and a second reflective region located between adjacent LED chips (4); and
a second encapsulating adhesive layer (46) arranged on the front side of the first substrate (1) and covering the LED chips (4) and a light shielding layer (47) arranged on the second encapsulating adhesive layer (46); the light shielding layer (47) having light transmitting holes (471) corresponding to the LED chips (4); the light shielding layer (47) being a black target molecule layer obtained by depositing a black target (94) by magnetron sputtering; and/or the capsule further comprising a third encapsulating adhesive layer (48) arranged on the light shielding layer (47).

9. The LED light source assembly according to claim 7, **characterized in that** the LED light source assembly further comprises a light guide plate (6) arranged on the front side of the first substrate (1), and a back side of the light guide plate (6) is provided with accommodating grooves (61) corresponding to the LED chips (4), such that after the back side of the light guide plate (6) is bonded to the front side of the first substrate (1), the LED chips (4) are located in the accommodating grooves (61); and a front side of the light guide plate (6) is provided with diffusion portions (62) corresponding to the accommodating grooves (61).

10. A manufacturing method for an LED light source assembly, **characterized in that** the manufacturing method for the LED light source assembly comprises:
manufacturing a substrate (3) by the manufacturing method for the substrate (3) according to claim 5;
transferring LED chips (4) into die bonding regions on the substrate (3); and
electrically connecting the LED chips (4) in the die bonding regions to corresponding electrode soldering regions.

11. The manufacturing method for the LED light source assembly according to claim 10, **characterized in that** the transferring an LED chips (4) into die bonding regions on the substrate (3) comprises:
aligning the LED chips (4) bonded on a carrier tape body (8) with the die bonding regions on the substrate (3), front sides of the LED chips (4) being bonded to the carrier tape body (8) through a bonding layer (81), back sides of the LED chips (4) being provided with positive and negative electrodes, and the back sides of the LED chips (4) facing the substrate (3);
applying pressure to the carrier tape body (8) towards the substrate (3) to make the carrier tape body (8) deform until the electrodes of the LED chips (4) contact the corresponding electrode soldering regions in the die bonding region; and
debonding the bonding layer (81) to make the LED chips (4) fall from the carrier tape body (8) into the corresponding die bonding regions;
wherein the bonding layer (81) is a photolytic adhesive layer, the debonding the bonding layer (81) comprising: illuminating the bonding layer (81) by light to debond the bonding layer (81); or the bonding layer (81) is a pyrolytic adhesive layer, the debonding the bonding layer (81) comprising: heating the bonding layer (81) to debond the bonding layer (81);
wherein at least one of a first substrate (1) and a second substrate (2) is formed with a cutting mark (16) for indicating a cutting position, after the electrically connecting the LED chips (4) in the die bonding regions to corresponding electrode soldering regions, the method further comprising:
performing cutting according to the cutting position indicated by the cutting mark (16), so that second through holes (21) are cut into two parts and second metal conductive layers on side walls of the second through holes (21) constitute parts of an external soldering region.

12. The manufacturing method for the LED light source assembly according to claim 10, **characterized in that** after the electrically connecting the LED chips (4) in the die bonding regions to corresponding electrode soldering regions, the method further comprises:
forming an encapsulating adhesive covering the die bonding regions and the LED chips (4) in the die bonding regions on a front side of the first substrate (1);
removing the encapsulating adhesive around each die bonding region respectively by cutting to obtain a reflective adhesive layer groove, the encapsulating adhesive in one die bonding region after cutting constituting one encapsulating adhesive unit (51); and
forming a first reflective adhesive layer (53) respectively enclosing the encapsulating adhesive unit (51) in each die bonding region in the reflective adhesive layer groove.

13. The manufacturing method for the LED light source assembly according to claim 10, **characterized in that** after the electrically connecting the LED chips (4) in the die bonding regions to corresponding electrode soldering regions, the method further comprises:
forming a second encapsulating adhesive layer (46) covering the die bonding regions and the LED chips (4) in the die bonding regions on a front side of the first substrate (1);
placing a black target (94) on a platform with a magnetic field (96), and placing the substrate (3) opposite to the black target (94), the second encapsulating adhesive layer (46) being opposite to the black target (94); and
covering first regions (911) on the second encapsulating adhesive layer (46) corresponding to each of the LED chips (4) with masks, and depositing the black target (94) onto a surface of the second encapsulating adhesive layer (46) by magnetron sputtering to form a black target molecule layer, the black target molecule layer constituting a black matrix;
wherein the covering first regions (911) on the second encapsulating adhesive layer (46) corresponding to each of the LED chips (4) with masks, and depositing the black target (94) onto a surface of the second encapsulating adhesive layer (46) by magnetron sputtering to form a black target molecule layer comprises:
arranging first masks (91) on the second encapsulating adhesive layer (46), the first masks (91) covering the first regions (911) and second regions (912) on the second encapsulating adhesive layer (46);
performing sputtering on the second encapsulating adhesive layer (46) to make the black target (94) deposit onto regions on the second encapsulating adhesive layer (46) other than the first regions (911) and the second regions (912);
removing the first mask (91), and arranging second masks (92) on the second encapsulating adhesive layer (46), the second masks (92) covering the first regions (911) and third regions on the second encapsulating adhesive layer (46), and the third regions being not overlapped with the second regions (912); and
performing sputtering on the second encapsulating adhesive layer (46) again to make the black target (94) deposit onto regions on the second encapsulating adhesive layer (46) other than the first regions (911) and the third regions;
or
covering the second encapsulating adhesive layer (46) with a mask material;
removing the mask material on the second encapsulating adhesive layer (46) in regions other than the first regions (911) to form a mask layer; and
performing magnetron sputtering on the second encapsulating adhesive layer (46) formed with the mask layer to make the black target (94) deposit onto the regions on the second encapsulating adhesive layer (46) other than the first regions (911).
